(19) Europäisches Patentamt
European Patent Office
Office européen des brevets

(11) **EP 4 261 728 A1**

(12) **EUROPEAN PATENT APPLICATION**

(43) Date of publication:
**18.10.2023 Bulletin 2023/42**

(51) International Patent Classification (IPC):
**G06F 30/13** (2020.01)   **G06F 30/20** (2020.01)
**G06F 30/15** (2020.01)

(21) Application number: **23151984.4**

(22) Date of filing: **17.01.2023**

(52) Cooperative Patent Classification (CPC):
**G06F 30/13; G06F 30/15; G06F 30/20**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **15.04.2022 JP 2022067783**

(71) Applicants:
• **FUJITSU LIMITED**
  **Kawasaki-shi, Kanagawa 211-8588 (JP)**

• **Fujitsu Limited**
  **Kawasaki-shi, Kanagawa 211-8588 (JP)**

(72) Inventors:
• **Takahashi, Eiichi**
  **Kawasaki-shi, Kanagawa, 211-8588 (JP)**
• **Yamaoka, Hisatoshi**
  **Kawasaki-shi, Kanagawa, 211-8588 (JP)**
• **Okabayashi, Miwa**
  **Kawasaki-shi, Kanagawa, 211-8588 (JP)**

(74) Representative: **Hoffmann Eitle**
**Patent- und Rechtsanwälte PartmbB**
**Arabellastraße 30**
**81925 München (DE)**

(54) **SIMULATION METHOD AND SIMULATION PROGRAM**

(57)    A simulation method implemented by a computer, the simulation method including: classifying, in processor circuitry of the computer (1), a plurality of regions into a first region where a first simulation is performed with a predetermined resolution and a second region where a second simulation is performed with a lower resolution than the first region, based on a relationship between a density and a speed of a vehicle in each of the plurality of regions (12); performing, in the processor circuitry of the computer, the first simulation for the first region; and performing, in the processor circuitry of the computer, the second simulation for the second region.

FIG. 1

**Description**

FIELD

The embodiment discussed herein is related to a simulation method and a simulation program.

BACKGROUND

A traffic simulator that reproduces a traffic phenomenon such as a congestion on a computer is used in urban planning, traffic policy evaluation, or the like. A simulation performed by the traffic simulator includes three models according to a resolution.

One is a macro model with the lowest resolution. The macro model assumes all vehicles in a certain range as one vehicle group and reproduces a traffic phenomenon as a behavior based on fluid dynamics or the like. Although the macro model does not reproduce a behavior of each vehicle, the macro model is often used for a wide-area simulation because of high calculation efficiency and low calculation cost.

Another one is a micro model with the highest resolution. The micro model is a detailed model that reflects a performance and driving characteristics for each vehicle and can reproduce a behavior close to reality. However, since the micro model performs a large amount of calculations, calculation cost of the micro model is high, and the micro model is often used for a simulation in a very small region.

The remaining one is a meso model with an intermediate resolution between the macro model and the micro model. Although the meso model uses vehicles individually, similarly to the micro model, the meso model simplifies the behavior of the vehicle by approximating a road in blocks (for example, 500 m) or a road between intersections with a queue or the like. Although the meso model reproduces a travel route of each vehicle or the like, the meso model does not reproduce a detailed behavior such as acceleration, deceleration, or lane change on roads or at intersections. Although calculation cost of the meso model is not low as that of the macro model, the calculation cost is much lower than that of the micro model. For example, the calculation cost of the meso model is suppressed to about one hundredth of the micro model. The meso model is often used for a wide-area simulation about at a city level.

In recent years, with increasing complexity of problems such as $CO_2$ reduction, both of the resolution and the wide area have been requested for the simulation of the traffic phenomenon. However, when a wide area is simulated with high resolution by simply using the micro model, the calculation amount is very large and the calculation cost becomes enormous. Therefore, it has been difficult to perform the simulation in practical.

Therefore, as a technique that achieves both of the resolution and the wide area, a hybrid simulation technology has been proposed. When a user specifies a region on a map that the user desires to focus, the hybrid simulation technology simulates the specified region with the micro model and simulates other region with the meso model. By setting the focused region to have high resolution and the other wide region to have low resolution, the hybrid simulation technology achieves both of the resolution and the wide area.

Furthermore, a traffic simulation technique for mutually converting an individual vehicle and a vehicle group by providing a buffer area for connection between the micro model and the macro model has been proposed.

In addition to the traffic simulation, a technique has been proposed that performs compression expression with voxels depending on a space density of particles. With this technique, a region in which particles are dense is covered with small voxels and simulated with high resolution, and other region is covered with large voxels and is simulated with low resolution. In this way, it is possible to hold space information of particles corresponding to the high resolution while suppressing a data size of the entire region. When this idea is applied to the traffic simulation, it is considered to simulate a region with high density of vehicles with the micro model and simulate other region with the meso model.

Japanese Laid-open Patent Publication No. 2002-269670 is disclosed as related art.

SUMMARY

TECHNICAL PROBLEM

However, in the simulation of the traffic phenomenon, it may be difficult for the user to specify a region to be simulated with the micro model. For example, in a case where an effect of a road pricing policy for changing tolls is evaluated, a traffic flow largely charges due to an increase in the number of vehicles that select a detour or the like. As a result, a congestion may occur in another place. However, it is difficult to predict when and how the congestion occurs, and it is difficult for the user to specify the region to be simulated with the micro model. Therefore, it is considered to set a region of the micro model to be wider to some extent. However, it is difficult to reduce a calculation amount and sufficiently suppress calculation cost with this, and in addition, there is a possibility that it is difficult to reliably capture occurrence of a congestion with the micro model.

When a region with high density of objects such as vehicles is assumed as the micro model, even if the user does not specify the region in advance, it is possible to set the regions of the micro model and the meso model according to a situation of the simulation. In this case, since the vehicle density is used as a reference for region setting, a region that is already in a congested state is assumed as the region of the micro model. However, even with the meso model with low resolution, a behavior of a vehicle in the congested state can be simulated with accuracy corresponding to that of the micro model. This is because, since the vehicle in the congested state does not accelerate or decelerate, change lanes, or the like, the vehicle in the congested state is not largely different from a vehicle in a normal traveling state other than that the vehicle in the congested state travels at low speed and has a short inter-vehicle distance. As a result, there is no significant difference between the micro model and the meso model regarding reproduction of the behavior of the vehicle in the congested state.

Here, the calculation amount of the traffic simulation is mainly proportional to the number of vehicles. In a congested state, the number of vehicles existing on the road is large. In a case where a region is set depending on the vehicle density, although the vehicle in the congested state can be sufficiently simulated by the meso model with a small calculation amount and low calculation cost, the vehicle in the congested state is simulated by the micro model. Therefore, it is difficult to reduce the calculation amount and sufficiently suppress the calculation cost.

In order to reduce the calculation amount and sufficiently suppress the calculation cost, it is preferable to simulate a region where a congestion is likely to occur with the micro model, not a region where a congestion occurs, and simulate other region with the meso model.

The disclosed technology has been made in consideration of the above, and an object of the disclosed technology is to provide a simulation method and a simulation program that perform a simulation with high accuracy while suppressing a calculation amount.

SOLUTION TO PROBLEM

According to an aspect of the embodiments, there is provided a simulation method implemented by a computer, the simulation method including: classifying, in processor circuitry of the computer, a plurality of regions into a first region where a first simulation is performed with a predetermined resolution and a second region where a second simulation is performed with a lower resolution than the first region, based on a relationship between a density and a speed of a vehicle in each of the plurality of regions; performing, in the processor circuitry of the computer, the first simulation for the first region; and performing, in the processor circuitry of the computer, the second simulation for the second region.

ADVANTAGEOUS EFFECTS OF INVENTION

In one aspect, the embodiment can perform a simulation with high accuracy while suppressing a calculation amount.

BRIEF DESCRIPTION OF DRAWINGS

FIG. 1 is a block diagram of a traffic simulation device according to an embodiment;
FIG. 2 is a diagram illustrating an example of map information;
FIG. 3 is a diagram illustrating an example of micro information;
FIG. 4 is a diagram illustrating an example of meso information;
FIG. 5 is a diagram for explaining a correspondence between a micro model and a meso model;
FIG. 6 is a diagram for explaining a metastable state;
FIG. 7 is a diagram illustrating a relationship between a vehicle density and a traffic flow according to a vehicle speed;
FIG. 8 is a diagram illustrating an example of road information;
FIG. 9 is a diagram illustrating an optimum speed model;
FIG. 10 is a diagram for explaining a method for calculating a set value $\delta$;
FIG. 11 is a diagram illustrating an example of vehicle information;
FIG. 12 is a diagram illustrating a case where a vehicle enters a road in a different model region as the vehicle moves;
FIG. 13 is a diagram for explaining a method for setting vehicle information in a case where the vehicle moves to a different type of a model region;
FIG. 14 is a diagram illustrating a case where a model region of a road where a vehicle exists changes;
FIG. 15 is a diagram for explaining a method for setting vehicle information in a case where the road where the vehicle exists is transitioned to a different type of the model region;
FIG. 16 is a flowchart illustrating an operation of an entire simulation;

FIG. 17 is a flowchart of processing for dividing a road into a micro model region and a meso model region;

FIG. 18 is a flowchart of processing for determining whether the metastable state is established;

FIG. 19 is a flowchart of processing for determining a model region of a target road;

FIG. 20 is a flowchart of vehicle transfer processing between simulators;

FIG. 21 is a flowchart of transfer processing of a vehicle that moves from the meso model region to the micro model region;

FIG. 22 is a flowchart of movement processing of a vehicle that moves from the micro model region to the meso model region;

FIG. 23 is a flowchart of transfer processing of a vehicle on a road that has changed from the meso model region to the micro model region;

FIG. 24 is a flowchart of transfer processing of a vehicle on a road that has changed from the micro model region to the meso model region;

FIG. 25 is a hardware configuration diagram of the traffic simulation device according to the embodiment; and

FIG. 26 is a diagram illustrating another configuration example of the traffic simulation device.

DESCRIPTION OF EMBODIMENTS

Hereinafter, an embodiment of a simulation method and a simulation program disclosed in the present application will be described in detail with reference to the drawings. Note that the simulation method and the simulation program disclosed in the present application are not limited to the following embodiment.

[Embodiments]

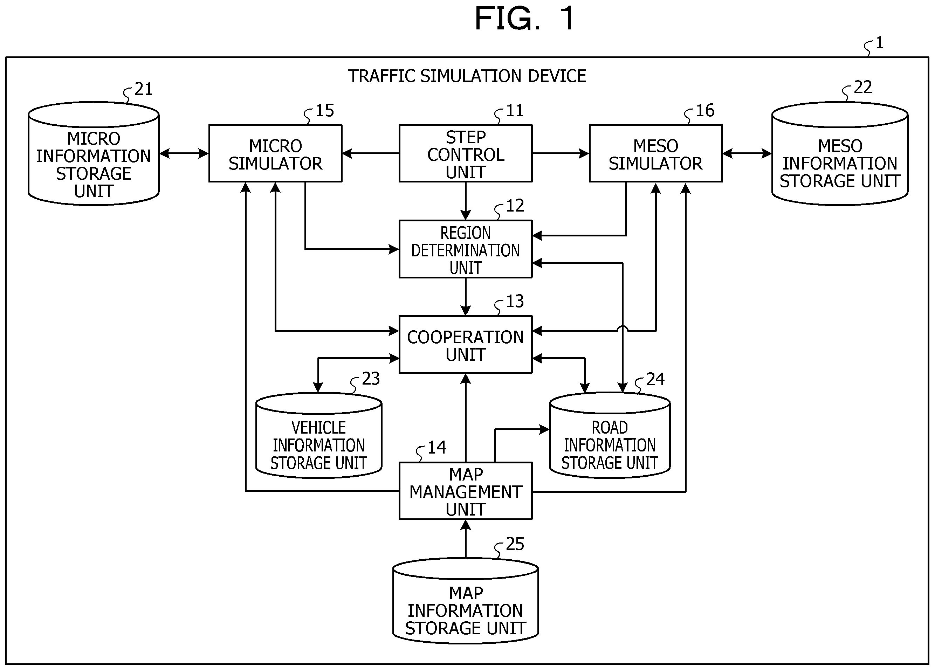

FIG. 1 is a block diagram of a traffic simulation device according to an embodiment. As illustrated in FIG. 1, a traffic simulation device 1 according to the present embodiment includes a step control unit 11, a region determination unit 12, a cooperation unit 13, a map management unit 14, a micro simulator 15, and a meso simulator 16. Furthermore, the traffic simulation device 1 includes a micro information storage unit 21, a meso information storage unit 22, a vehicle information storage unit 23, a road information storage unit 24, and a map information storage unit 25. Hereinafter, a region where a simulation is performed using a micro model is referred to as a "micro model region", and a region where a simulation is performed using a meso model is referred to as a "meso model region". Furthermore, the micro model region and the meso model region are collectively referred to as a "model region".

The step control unit 11 holds a one-step interval of a simulation in advance. For example, the one-step interval may be one second or one minute. The step control unit 11 starts to measure a step interval from start of the simulation. Then, the step control unit 11 advances simulation steps one by one.

After advancing one simulation step, the step control unit 11 receives a notification of vehicle movement processing completion between the micro simulator 15 and the meso simulator 16 from the cooperation unit 13. Then, upon receiving the notification of the vehicle movement processing completion, the step control unit 11 outputs an advance instruction to a next step to the micro simulator 15 and the meso simulator 16 and advances the simulation by one step. Moreover, the step control unit 11 instructs the region determination unit 12 to determine a region each time when advancing the micro simulator 15 and the meso simulator 16 by one step.

Thereafter, the step control unit 11 determines whether the total number of steps executed in the simulation is the set number of ending steps. If the total number of steps does not reach the number of ending steps, the step control unit 11 waits for a next notification of vehicle movement processing completion and advances the step thereafter. On the other hand, in a case where the total number of steps has reached the number of ending steps, the step control unit 11 ends the simulation.

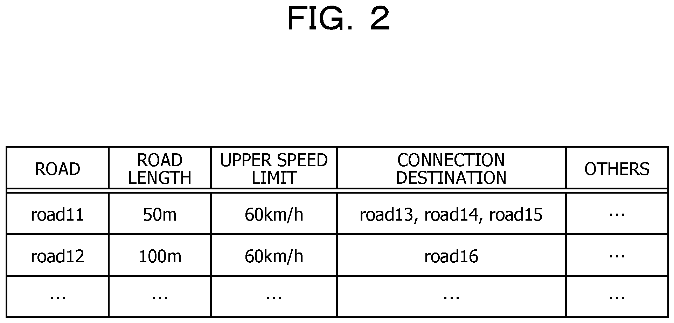

The map management unit 14 acquires map information that includes lengths and connections of roads from the map information storage unit 25. FIG. 2 is a diagram illustrating an example of the map information. For example, as illustrated in FIG. 2, the map information includes a length of each road, a speed limit of each road, and information regarding a connection destination that is information regarding another road to which the road is connected, in association with identification information assigned to each road. Furthermore, the map information may include, for example, another piece of information such as a list of position information of polygonal lines indicating roads.

Here, in the present embodiment, when the road is an ordinary road, for example, in a case where a section between intersections or a distance between intersections is long, each section obtained by dividing the distance into a predetermined length is assumed as a unit of the road. Furthermore, in a case of an expressway, for example, each section divided by 1 km is assumed as a unit of the road.

Then, the map management unit 14 outputs the map information to the micro simulator 15, the meso simulator 16, and the cooperation unit 13. Furthermore, the map management unit 14 creates road information in which information regarding all roads included in the map information is registered, assigns an initial state of a model region to each road, and stores the created road information in the road information storage unit 24. For example, the map management unit 14 may assume all the roads as the meso model region as the initial state of the model region or may assume a road, in which a traffic congestion is likely to occur, designated in advance as the micro model region and assume other roads as the meso model region.

The micro simulator 15 is a simulator that reproduces a traffic phenomenon using a micro model. The micro simulator 15 acquires the map information from the map management unit 14. Furthermore, the micro simulator 15 acquires micro information such as a position or a speed of a vehicle existing on a road that is set as a micro model region stored in the micro information storage unit 21, from the micro information storage unit 21.

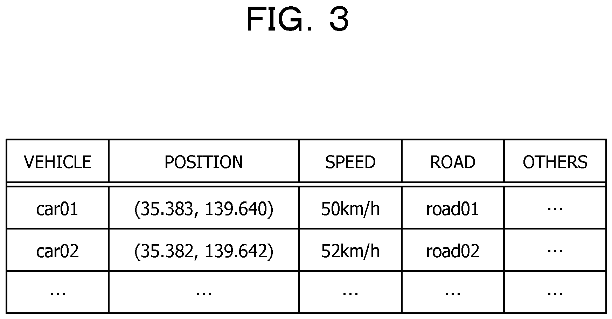

FIG. 3 is a diagram illustrating an example of the micro information. For example, as illustrated in FIG. 3, the micro information includes a latitude and longitude of a location where a vehicle is positioned, a speed of the vehicle, and identification information of a road where the vehicle exists, for each vehicle. Moreover, in the micro information, for example, another piece of information including information regarding a travel route and a travel time of each vehicle or the like may be registered.

Moreover, in a case where a vehicle exists of which a staying road has changed from the micro model region to the meso model region due to a movement of the vehicle or a change of a model region of the road, the micro simulator 15 receives an instruction to delete information regarding the vehicle from the micro information from the cooperation unit 13. Then, the micro simulator 15 deletes the information regarding the vehicle from the micro information.

Furthermore, in a case where a vehicle exists of which a staying road has changed from the meso model region to the micro model region due to a movement of the vehicle, the micro simulator 15 receives an input of the micro information indicating that the vehicle exists at a position of a starting point of the staying road at that time, from the cooperation unit 13. Then, the micro simulator 15 adds the acquired micro information of the vehicle to the holding micro information.

Furthermore, in a case where a vehicle exists of which a staying road has changed from the meso model region to the micro model region due to a change of a model region of the road, the micro simulator 15 receives an input of the micro information storing a position and a speed of the vehicle at that time and identification information of the staying road, from the cooperation unit 13. Then, the micro simulator 15 adds the acquired micro information of the vehicle to the holding micro information.

The micro simulator 15 receives a step advance instruction from the step control unit 11 and advances one step. Then, the micro simulator 15 calculates a position and a speed of the vehicle one step after, using the map information and the micro information. Thereafter, the micro simulator 15 updates the micro information stored in the micro information storage unit 21. As a result, the micro simulator 15 reproduces a behavior of the vehicle in detail based on the map information and the micro information.

The meso simulator 16 is a simulator that reproduces a traffic phenomenon using the meso model. The meso simulator 16 acquires the map information from the map management unit 14. Furthermore, the meso simulator 16 acquires meso information such as information or a staying time of a vehicle existing on a road set as the meso model region from the meso information storage unit 22.

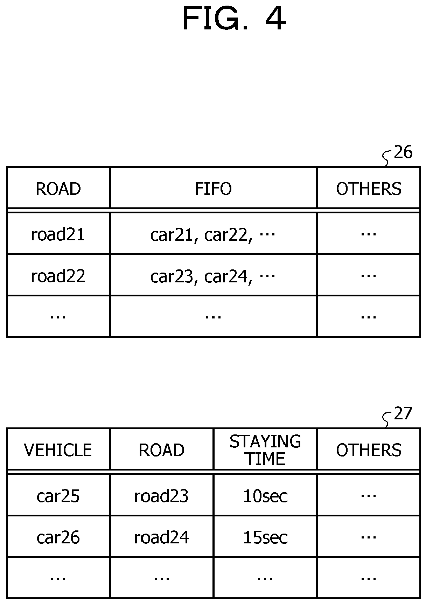

FIG. 4 is a diagram illustrating an example of the meso information. For example, as illustrated in FIG. 4, the meso information includes meso road information 26 and meso vehicle information 27.

In the meso road information 26, information regarding a vehicle existing on each road is registered, in association with the identification information of each road set as the meso model region. In the meso road information 26, a position of the vehicle on each road is represented using a queue. For example, a fast in fast out (FIFO) field of the meso road information 26 holds identification information regarding vehicles existing on a road in an order in which the vehicles enter the road. For example, the FIFO field in FIG. 4 indicates that vehicles car21, car22,... exist on a road road21 in this order. Moreover, the meso road information 26 may include another piece of information such as a time in a case of passing at the upper speed limit.

In the meso vehicle information 27, identification information of a road where each vehicle exists and a staying time of each vehicle on the road are registered, in association with the identification information of each vehicle. The staying time is an elapsed time from a time when the vehicle has entered the road. For example, the meso vehicle information 27 in FIG. 4 indicates that 10 seconds are elapsed from a time when a vehicle car25 has entered a road road23. Moreover, the meso vehicle information 27 may include another piece of information such as travel route information or a travel time of each vehicle.

Moreover, in a case where a vehicle exists of which a staying road has changed from the meso model region to the micro model region due to the movement of the vehicle or the change of the model region of the road, the meso simulator 16 receives an instruction to delete information regarding the vehicle from the meso information, from the cooperation unit 13. Then, the meso simulator 16 deletes the information regarding the vehicle from a queue of the staying road of the vehicle in the holding meso road information. Moreover, the meso simulator 16 deletes the information regarding the vehicle from the holding meso vehicle information.

Furthermore, in a case where a vehicle exists of which a staying road has changed from the micro model region to the meso model region due to the movement of the vehicle, the meso simulator 16 receives an input of information regarding the staying road where the vehicle stays and meso information in which a staying time is set to zero, from the cooperation unit 13. Then, the meso simulator 16 adds the acquired meso vehicle information of the vehicle to the meso vehicle information of the holding meso information. Furthermore, the meso simulator 16 receives an instruction to add information regarding a target vehicle to the end of the queue of the staying road of the vehicle in the meso road information, from the cooperation unit 13. Then, the meso simulator 16 adds the information regarding the target vehicle to the end of the queue of the staying road of the vehicle in the holding meso road information.

Furthermore, in a case where a vehicle exists of which a staying road has changed from the micro model region to the meso model region due to the change of the model region of the road, the meso simulator 16 receives an input of the meso information in which information regarding the staying road where the vehicle stays and a staying time are registered, from the cooperation unit 13. Then, the meso simulator 16 adds the acquired meso vehicle information of the vehicle to the meso vehicle information of the holding meso information. Furthermore, the meso simulator 16 receives an instruction to add the information regarding the vehicle to the queue of the staying road in the meso road information in the meso information according to the staying time, from the cooperation unit 13. Then, the meso simulator 16 adds information regarding the target vehicle to a position according to the staying time, in the queue of the staying road of the vehicle in the holding meso road information.

The meso simulator 16 receives a step advance instruction from the step control unit 11 and advances one step. Then, the meso simulator 16 calculates a road where the vehicle exists one step later and a staying time, using the map information and the holding meso information. Thereafter, the meso simulator 16 updates the meso information stored in the meso information storage unit 22. As a result, the meso simulator 16 reproduces a simplified behavior of the vehicle, based on the map information and the meso information.

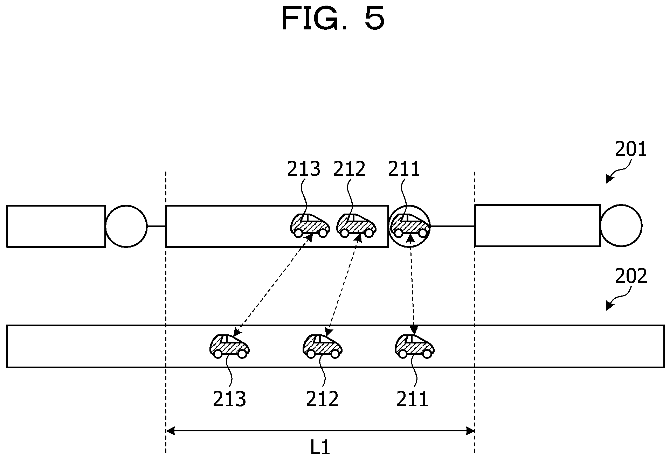

Here, a correspondence relationship between a vehicle in the micro model and a vehicle in the meso model will be described. FIG. 5 is a diagram for explaining a correspondence between the micro model and the meso model. In a simulation using the micro model, a movement of a vehicle is precisely reproduced using a position and a speed of each vehicle as in a road 202 in FIG. 5. On the other hand, in a simulation using the meso model, a movement of a vehicle is simplified and reproduced using a queue indicating an arrangement of vehicles in an entering order and a staying time of each vehicle as in a road 201 in FIG. 5.

Then, since a position on the micro model can be calculated using a staying time and a speed in the meso model, a corresponding position on the micro model of the vehicle entered in the queue in the meso model can be calculated. That is, staying times of respective vehicles 211 to 213 that exist in a queue on the road 201 of the meso model are times t1 to t3, it is determined which position on the road 202 having a length L1 of the micro model the vehicles 211 to 213 exist, using the time t1 to t3. Furthermore, conversely, the queue in the meso model is created from the position on the micro model, and the staying time is calculated from the position and the speed.

Returning to FIG. 1, the description will be continued. Upon receiving an instruction to determine a region from the step control unit 11, the region determination unit 12 collects information regarding a position and a speed of each vehicle from the micro simulator 15 and the meso simulator 16. Then, the region determination unit 12 determines the micro model region where a simulation is performed using the micro model and the meso model region where a simulation is performed using the meso model.

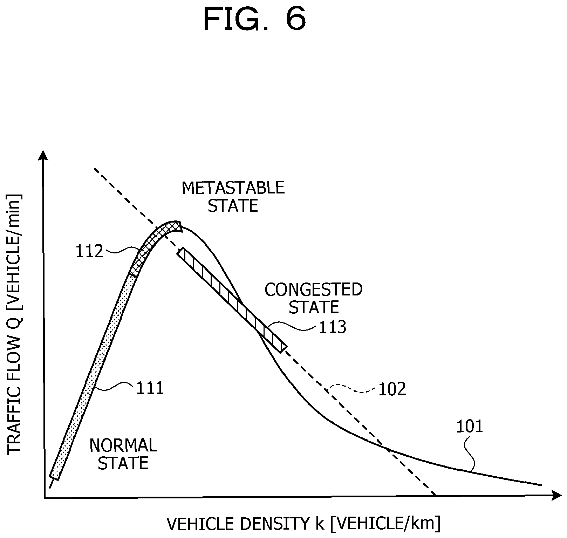

Here, a metastable state used for processing for determining the micro model region and the meso model region by the region determination unit 12 will be described. FIG. 6 is a diagram for explaining the metastable state. The horizontal axis of the graph indicates a vehicle density, and the vertical axis indicates a traffic flow. The vehicle density is, for example, the number of vehicles per unit distance such as 1 km. The traffic flow is, for example, the number of vehicles that pass through in a unit time such as one minute.

A curve 101 indicates a relationship between the vehicle density and the traffic flow. A region 111 in the curve 101 indicates a normal state that is a state where vehicles are smoothly moving, and a vehicle speed and an inter-vehicle distance are substantially fixed. In the normal state, the traffic flow increases as the vehicle density becomes higher.

A straight line 102 indicates a relationship between a vehicle density and a traffic flow in a congested state. As indicated by the straight line 102, the traffic flow decreases as the vehicle density is higher, in the congested state. This is due to a decrease in the vehicle speed. Then, a region 113 in the curve 101 approximated by the straight line 102 indicates a congested state.

Even in the normal state in the region 111 and the congested state in the region 113, the vehicle does not often accelerate or decelerate, change lanes, or the like, and the vehicle speed and the inter-vehicle distance do not largely change. Therefore, in the normal state in the region 111 and the congested state in the region 113, it is possible to sufficiently reproduce the behavior of the vehicle with the meso model. On the other hand, a region 112 near an intersection with the straight line 102 including a maximum value of the curve 101 is usually a region that transitions from the normal state to the congested state and is referred to as a metastable state.

In the metastable state in the region 112, a small accidental acceleration, deceleration or the like of a certain vehicle in a line of vehicles induces an acceleration, deceleration, or the like of the following vehicle, and this propagates to the following vehicle. This results in that smooth traveling is suddenly changed to a congested state. It is difficult to reproduce this phenomenon with the simulation using the meso model, and this phenomenon is preferably treated with the simulation using the micro model. For that purpose, a road in the state of the region 112 may be assumed as the micro model region.

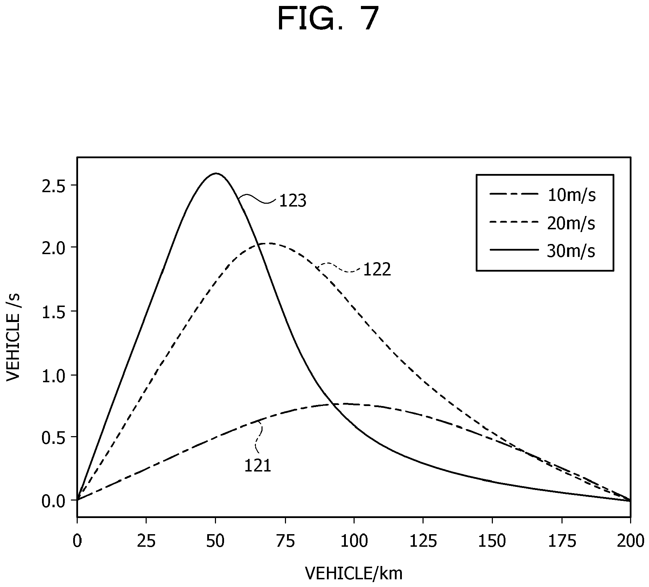

Here, the curve 101 is determined according to a speed of a vehicle. FIG. 7 is a diagram illustrating a relationship between the vehicle density and the traffic flow according to the vehicle speed. The horizontal axis in FIG. 7 indicates the vehicle density, and the vertical axis indicates the traffic flow. In FIG. 7, a graph 121 represents a case where the vehicle speed is 10 m/s, a graph 122 represents a case where the vehicle speed is 20 m/s, and a graph 123 represents a case where the vehicle speed is 30 m/s. That is, a position of the region 112 that is the metastable state near the maximum value of the curve 101 in FIG. 7 differs depending on the vehicle speed. The higher speed causes the metastable state with the lower vehicle density.

Therefore, the region determination unit 12 specifies the curve 101 from the vehicle speed, using the relationship between the vehicle density and the traffic flow according to the vehicle speed as illustrated in FIG. 7. Then, the region determination unit 12 obtains a vehicle density from a vehicle distribution at that time and can determine whether a target road is in the metastable state from the vehicle density at that time, using the specified curve 101.

Returning to FIG. 1, the description will be continued. The region determination unit 12 determines whether each road is in the metastable state. Thereafter, the region determination unit 12 determines which one of the micro model region and the meso model region each road is at that time from the road information, using the determination result indicating whether each road is in the metastable state. Hereinafter, details of processing for determining the micro model region and the meso model region by the region determination unit 12 will be described. Here, processing for determining a micro model region or a meso model region for one specific target road will be described as an example. The region determination unit 12 executes the following processing for all roads.

First, a specific example of processing for determining whether each road is in the metastable state will be described. The region determination unit 12 acquires road information of the target road from the road information storage unit 24. Then, the region determination unit 12 specifies a type of the model region of the target road at that time.

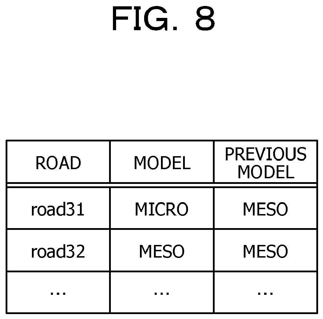

FIG. 8 is a diagram illustrating an example of the road information. As illustrated in FIG. 8, in a road field of the road information, identification information assigned to each road is registered. Furthermore, in a model field, information indicating which one of the micro model region or the meso model region each road is at that time is registered. In a previous model field, information indicating which one of the micro model region or the meso model region each road is at a previous step is registered. For example, in the road information illustrated in FIG. 8, a road road31 is the micro model region, and a road32 is the meso model region.

The region determination unit 12 acquires vehicle information of a vehicle on a road to be a target from the micro simulator 15 if the target road is the micro model region and acquires vehicle information on a road to be a target from the meso simulator 16 if the target road is the meso model region. Furthermore, the region determination unit 12 acquires map information of the target road held by the micro simulator 15 and the meso simulator 16. Then, the region determination unit 12 extracts a length and an upper speed limit of the target road from the map information. Here, in the present embodiment, the region determination unit 12 acquires the map information from the micro simulator 15 and the meso simulator 16. However, the region determination unit 12 may acquire the map information from the map management unit 14.

Next, the region determination unit 12 obtains a vehicle density k and a vehicle average speed v as follows. In a case where the target road is the micro model region, the region determination unit 12 calculates the vehicle density k at that time as assuming that $k = n/\sum \Delta x\_i$. Here, the reference n indicates the number of vehicles existing on a road to be a target, and $\Delta x\_i$ indicates an inter-vehicle distance obtained from a position of each vehicle. Furthermore, the region determination unit 12 calculates an average vehicle of a speed of each vehicle existing on the road to be the target and sets the average value as the vehicle average speed v.

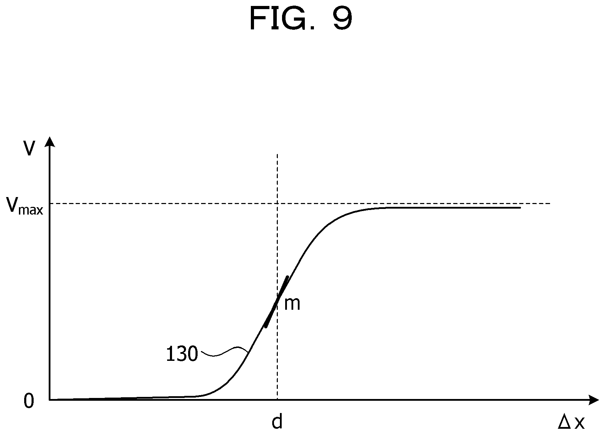

On the other hand, in a case where the road to be the target is the meso model region, the region determination unit 12 obtains the vehicle density k at that time as assuming that $k = n/L$, from the number of vehicles n and a road length L. Furthermore, the region determination unit 12 calculates the vehicle average speed v according to an optimum speed model illustrated in a graph 130 in FIG. 9. FIG. 9 is a diagram illustrating the optimum speed model. The horizontal axis in FIG. 9 indicates an inter-vehicle distance, and the vertical axis indicates a speed. Furthermore, the reference Vmax in FIG. 9 indicates an upper speed limit value of the road to be the target. The graph 130 in FIG. 9 is according to, for example, the following formula (1).

[Expression 1]

$$v = Vmax[tanh\ m(\Delta x - d) - tanh\ m(L\_c - d)] \qquad \cdots(1)$$

Here, the reference $\Delta x$ indicates an inter-vehicle distance, and $\Delta x = L/k$ is satisfied. Furthermore, the references d, m, and L_c are set values that are given in advance. The reference d indicates an inter-vehicle distance and is a value determined using a common-sense inter-vehicle distance according to the speed as a guide, and for example, d is set as 35 m or the like in a case where Vmax is 50 km/h. The reference m indicates a sensitivity of a driver to acceleration and deceleration, is a value that is empirically obtained, and is, for example, 0.2. The reference m corresponds to an inclination at d in the graph 130. The reference L_c is an average value of a vehicle length, and is 5 m, for example.

Next, the region determination unit 12 obtains a traffic flow function indicating a traffic flow Q, using the calculated vehicle density k and vehicle average speed v at that time. Next, the region determination unit 12 calculates a maximum value vehicle density k_p with the maximum value of the traffic flow function. The maximum value of the traffic flow function corresponds to a position where an inclination of a tangent of the traffic flow function is zero. For example, the region determination unit 12 calculates the maximum value vehicle density k_p according to the following procedure. The traffic flow Q is according to, for example, the following formula (2). Here, the reference v is represented by the formula (1). A curve represented by this formula (2) corresponds to the curve 101 illustrated in FIG. 6.

[Expression 2]

$$Q = k \cdot v(1/k) \qquad \cdots (2)$$

Next, the region determination unit 12 obtains Q' by differentiating the traffic flow Q by the vehicle density k. The reference Q' is according to, for example, the following formula (3).

[Expression 3]

$$Q^{'} = -\text{Vmax}(1 - a^2)m/k^2 \qquad \cdots (3)$$

Then, the region determination unit 12 assumes a vehicle density at which Q' = 0 in the formula (3) as the maximum value vehicle density k_p. For example, the region determination unit 12 calculates the maximum value vehicle density k_p using a bisection method or the like.

Next, the region determination unit 12 obtains a difference Δk = k_p - k between the vehicle density k and the maximum value vehicle density k_p at that time. Then, if the difference Δk is equal to or more than zero and is smaller than the set value δ, the region determination unit 12 determines that the target road is in the metastable state. On the other hand, if the difference Δk is less than zero or equal to or more than the set value δ, it is determined that the target road is not in the metastable state. Here, the region determination unit 12 can use a value that is obtained through an experiment, as δ. For example, the region determination unit 12 can set δ = 0.25 × k_p.

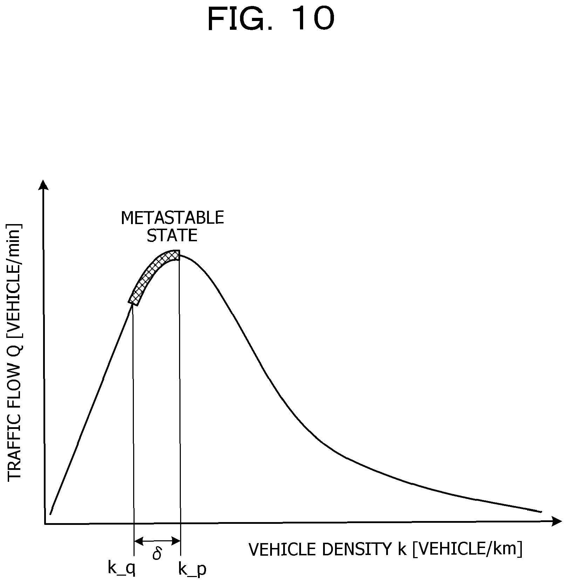

Here, the region determination unit 12 can also calculate the set value δ that is the lower limit value of the difference Δk between the maximum value vehicle density and the vehicle density at that time, with the following method. FIG. 10 is a diagram for explaining the method for calculating the set value δ. The horizontal axis in FIG. 10 indicates the vehicle density, and the vertical axis indicates the traffic flow.

For example, a speed under a situation where a state starts to be the metastable state, for example, congestion starts and an inter-vehicle distance starts to be shorter is assumed as βVmax. The reference Vmax indicates the maximum speed that can be achieved on a road on which a vehicle is traveling. Furthermore, the reference β is a coefFicient indicating a degree of deceleration. The reference β can be assumed, for example, as 0.98.

Then, the region determination unit 12 can calculate δ from the following formulas (4) to (6), using β and d, m, and L_c in the formula (1).

[Expression 4]

$$y = \beta + \tanh\big(m(L_c - d)\big) \qquad \cdots (4)$$

[Expression 5]

$$k\_q = \cfrac{1}{d + \cfrac{1}{2m}\log\left(\cfrac{1+y}{1-y}\right)} \qquad \cdots (5)$$

[Expression 6]

$$\delta = \mathrm{k\_p} - \mathrm{k\_q} \qquad \cdots (6)$$

The region determination unit 12 can obtain k_q in FIG. 10, according to the formula (5) obtained from the formula (4). Then, the region determination unit 12 can calculate the set value $\delta$ that is a lower limit value of the difference $\Delta$k between the maximum value vehicle density and the vehicle density at that time, by using the formula (6), from the maximum value vehicle density k_p and the obtained k_q.

After determining whether each road is in the metastable state with the above method, the region determination unit 12 determines which one of the micro model region or the meso model region each road is. Hereinafter, details of the processing for determining the micro model region or the meso model region by the region determination unit 12 will be described.

The region determination unit 12 acquires information in which a determination result indicating whether the target road is in the metastable state is added to the road information of the target road. If the target road is in the metastable state, the region determination unit 12 assumes the target road as the micro model region.

On the other hand, if the target road is not in the metastable state, the region determination unit 12 determines whether an end of the target road is an intersection. For example, in a case where the target road has a plurality of connection destinations in the map information illustrated in FIG. 2, the region determination unit 12 assumes that the end is the intersection. If the end is not the intersection, the region determination unit 12 assumes the target road as the meso model region.

Conversely, if the end is the intersection, the region determination unit 12 obtains an input traffic flow IQ (vehicle/s) to the target road and an output traffic flow OQ (vehicle/s) from the target road. Here, the region determination unit 12 obtains the input traffic flow IQ and the output traffic flow OQ as follows.

For each road connected to the target road, the region determination unit 12 assumes a road connected at an ending point, including the target road, as a road u_i (i = 1,..., n_u) and a road connected at a starting point as a road d_j (j = 1,..., n_d). Next, the region determination unit 12 calculates the number of vehicles n_i (vehicle), a vehicle speed v_i (m/s), and a vehicle line length L_i (m) for each road u_i.

Specifically, if the road u_i is the micro model region at this time, the region determination unit 12 calculates an average value of speeds of all vehicles staying on the road u_i as the vehicle speed v_i and calculates a total sum of the inter-vehicle distances of the respective vehicles as the vehicle line length L_i. Conversely, if the road u_i is the meso model region, the region determination unit 12 assumes the vehicle speed v_i as an upper speed limit and the vehicle line length L_i as a road length.

Moreover, the region determination unit 12 calculates an input traffic flow iq_i from each road u_i to the intersection at the end of the target road, using the following formula (7).
[Expression 7]

$$\mathrm{iq\_i} = \mathrm{v\_i} * \mathrm{n\_i} / \mathrm{L\_i} \qquad \cdots (7)$$

Then, the region determination unit 12 calculates a total sum of the input traffic flow iq_i to each road u_i (i = 1,..., n_u) connected to the intersection at the end of the target road at the ending point as the input traffic flow IQ to the target road, as indicated in the following formula (8).
[Expression 8]

$$\mathrm{IQ} = \sum \mathrm{iq\_i} \qquad \cdots (8)$$

Furthermore, the region determination unit 12 obtains the number of vehicles n_j (vehicle), a vehicle speed v_j (m/s), and a vehicle line length L_j (m) for all the roads d_j (j = 1,..., n_d) connected to the intersection at the end of the target road at the starting point, with a method similar to that of the road u_i. Thereafter, the region determination unit 12 calculates an output traffic flow oq_j from the intersection at the end of the target road to each road d_j using the following formula (9).
[Expression 9]

$$\mathrm{oq\_j} = \mathrm{v\_j} * \mathrm{n\_j} / \mathrm{L\_j} \qquad \cdots (9)$$

Then, the region determination unit 12 calculates a total sum of the output traffic flow oq_j of each road d_j (j = 1,..., n_d) connected to the intersection at the end of the target road at the starting point as the output traffic flow OQ from the target road, as indicated in the following formula (10).

[Expression 10]

$$OQ = \sum oq\_j \qquad \cdots (10)$$

Next, the region determination unit 12 obtains a ratio Rq between the input traffic flow IQ and the output traffic flow OQ. If the ratio Rq is smaller than preset $\alpha$, the region determination unit 12 assumes the target road as the meso model region. Conversely, if the ratio Rq is equal to or more than the preset o, the region determination unit 12 assumes the target road as the micro model region. Here, $\alpha$ can be obtained through experiments. For example, the reference $\alpha$ can be assumed as 1.1.

After determining whether each road is the micro model region or the meso model region as described above, the region determination unit 12 updates the road information stored in the road information storage unit 24 based on the determination result. Furthermore, the region determination unit 12 notifies the cooperation unit 13 of region determination completion for each step.

Here, since there is a high possibility that roads around the road determined as the micro model region transitions to a similar traffic state, the region determination unit 12 may set the micro model region including these regions. For example, the region determination unit 12 may assume a road ahead by predetermined n (m) in a vehicle traveling direction as the micro model region, as assuming the road determined as the micro model region as a starting point. The value n can be assumed as, for example, a distance in which a vehicle travels in a time period of one step of a simulation. Furthermore, the region determination unit 12 may assume a road included in a region of a radius r of the road determined as the micro model region, as the micro model region. The radius r can be, for example, a distance in which the vehicle travels in the time period of one step of the simulation.

In addition, the region determination unit 12 expresses a map with mesh layers having different resolutions and counts "the number of roads to be the micro model region in a mesh/the number of roads other than the micro model region" from a high resolution to a low resolution. Then, the region determination unit 12 may assume a mesh layer having the lowest resolution among the mesh layers of which the counting result is equal to or more than a set number as the micro model region.

That is, the region determination unit 12 creates a plurality of division patterns obtained by dividing a combined region, that includes the road determined as the micro model region and includes the plurality of roads, respectively into different numbers of parts and creates mesh layers according to the division number. Then, the region determination unit 12 obtains a ratio between the number of roads assumed as the micro model region included in the divided region and the number of roads other than the roads, for each divided region included in the mesh layers corresponding to the division pattern. That is, the region determination unit 12 obtains "the number of roads assumed as the micro model region/the number of roads other than the road assumed as the micro model region". Next, the region determination unit 12 specifies a divided region of which a ratio between the number of roads assumed as the micro model region included in the divided region and the number of roads other than the road is equal to or more than a preset value and a value of the ratio is the smallest. Then, the region determination unit 12 assumes a road included in the specified divided region as the micro model region.

The cooperation unit 13 receives the region determination completion notification for each step from the region determination unit 12. Then, the cooperation unit 13 acquires the road information from the road information storage unit 24. Furthermore, the cooperation unit 13 acquires the vehicle information from the vehicle information storage unit 23. Moreover, the cooperation unit 13 acquires the road information from the map management unit 14.

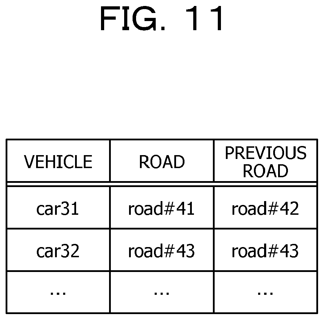

FIG. 11 is a diagram illustrating an example of the vehicle information. As illustrated in FIG. 11, the vehicle information includes identification information of a vehicle, identification information of a road on which each vehicle stays in a step at that time, and identification information of a road on which each vehicle stays in a previous step. For example, the vehicle information in FIG. 11 indicates that a vehicle car31 moves from a road road42 to a road41 and a vehicle car32 moves in a road road43.

Then, the cooperation unit 13 moves the vehicle between the micro simulator 15 and the meso simulator 16 according to which one of the micro model region or the meso model region each vehicle belongs. Hereinafter, details of the processing for moving the vehicle between the simulators by the cooperation unit 13 will be described. Here, vehicle movement processing for a specific target vehicle, executed by the cooperation unit 13, will be described. The cooperation unit 13 executes the following vehicle movement processing on all vehicles.

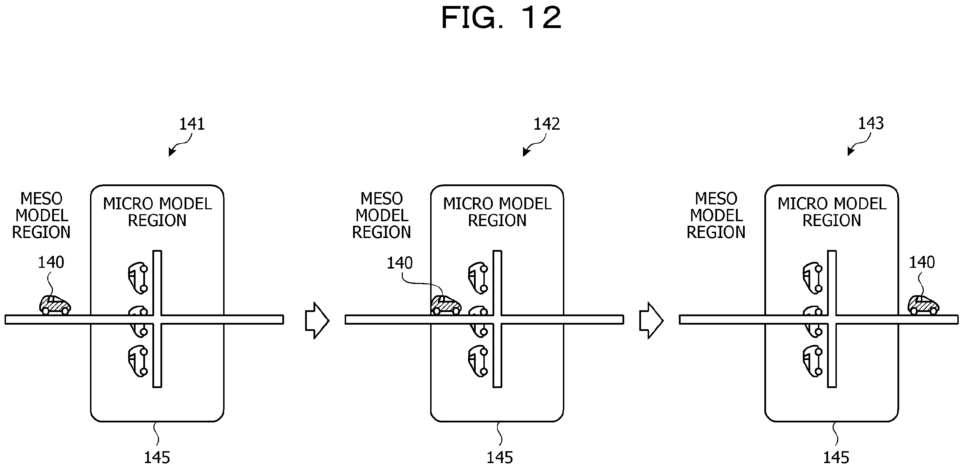

FIG. 12 is a diagram illustrating a case where a vehicle enters a road in a different model region as the vehicle moves. A region 145 in FIG. 12 corresponds to the micro model region. Furthermore, a region other than the region 145 corresponds to the meso model region. A transition from a state 141 to a state 142 indicates movement of a vehicle 140 from the meso model region to the micro model region. A transition from the state 142 to a state 143 indicates movement of the vehicle 140 from the micro model region to the meso model region.

The cooperation unit 13 acquires information regarding a target vehicle from the acquired vehicle information. Next, the cooperation unit 13 compares a current road that is a staying road of the target vehicle in the step at that time and a previous road that is a staying road of the target vehicle in a previous step.

If the current road is different from the previous road, the cooperation unit 13 acquires a model region of the current road and a previous model region of the previous road from the road information. Then, the cooperation unit 13 compares the model region of the current road and the previous model region of the previous road. If the model region of the current road and the previous model region of the previous road are the same, the cooperation unit 13 ends the vehicle movement processing between the simulators for the target vehicle.

On the other hand, in a case where the model region of the current road and the previous model region of the previous road are different, if the previous road is the meso model region, the cooperation unit 13 determines that the target vehicle has moved from the meso model region to the micro model region, as in the transition from the state 141 to the state 142 in FIG. 12. Then, the cooperation unit 13 instructs the meso simulator 16 to delete information regarding the target vehicle from the meso information. Next, since the identification information of the road is common between the micro information and the meso information, the cooperation unit 13 generates micro information indicating that the target vehicle exists at a position of a starting point of the current road. Then, the cooperation unit 13 outputs the generated micro information to the micro simulator 15. As a result, information regarding the target vehicle that has entered the road of the micro model region is newly added to the micro information.

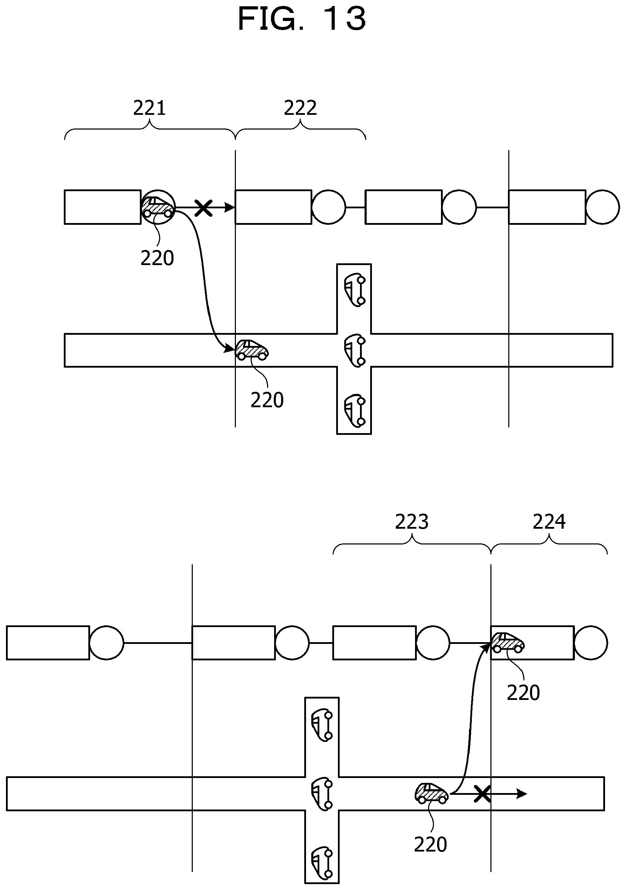

FIG. 13 is a diagram for explaining a method for setting vehicle information in a case where the vehicle moves to a different type of a model region. For example, in a case where a vehicle 220 enters from a road 221 in the meso model region into a road 222 in the micro model region, the cooperation unit 13 arranges the vehicle 220 at a starting point of the road 222 without putting the vehicle 220 that has moved out from a queue of the road 221 into a next queue.

Conversely, if the previous road is the micro model region, the cooperation unit 13 determines that the target vehicle has moved from the micro model region to the meso model region, as in the transition from the state 142 to the state 143 in FIG. 12. Then, the cooperation unit 13 instructs the micro simulator 15 to delete the information regarding the target vehicle from the micro information. Next, since the identification information of the road is common between the micro information and the meso information, the cooperation unit 13 notifies the meso simulator 16 of an instruction to add the information regarding the target vehicle to the end of the queue of the current road in the meso road information in the meso information. Moreover, the cooperation unit 13 generates the meso vehicle information indicating that the target vehicle exists on the current road and the staying time is zero. Then, the cooperation unit 13 outputs the generated meso vehicle information to the micro simulator 15. As a result, the information regarding the target vehicle that has entered the road in the meso model region is newly added to the meso information.

For example, as illustrated in FIG. 13, in a case where the vehicle 220 has entered from a road 223 in the micro model region and a road 224 in the meso model region, the cooperation unit 13 adds the vehicle 220 to a tail end of a queue of the road 224 without placing the vehicle 220 that has moved out from the road 223 at a starting point of the road.

On the other hand, in a case where the current road and the previous road are the same, the cooperation unit 13 acquires information regarding a current model region that is a model region of the current road at that time and a previous model region that is a model region in the previous step, from the acquired road information. Then, the cooperation unit 13 compares the current model region and the previous model region. If the current model region and the previous model region are the same, the cooperation unit 13 ends the vehicle movement processing between the simulators for the target vehicle. On the other hand, in a case where the current model region and the previous model region are different, the cooperation unit 13 executes the following processing.

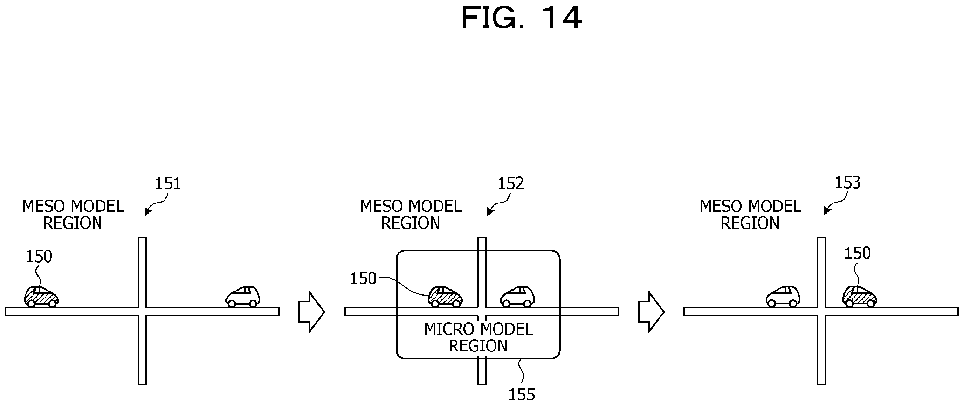

FIG. 14 is a diagram illustrating a case where a model region of a road where a vehicle exists changes. A region 155 in FIG. 14 corresponds to the micro model region. Furthermore, a region other than the region 155 corresponds to the meso model region. A transition from a state 151 to a state 152 indicates that vicinity of an intersection changes from the meso model region to the micro model region. Furthermore, a transition from the state 152 to a state 153 indicates that the vicinity of the intersection changes from the micro model region to the meso model region.

In a case where the previous model region is the meso model region and the current model region is the micro model region, the cooperation unit 13 determines that the road on which the target vehicle exists has changed from the meso model region to the micro model region, as in the transition from the state 151 to the state 152 in FIG. 14. Then, the cooperation unit 13 acquires the information regarding the target vehicle in the meso information from the meso simulator 16. Next, the cooperation unit 13 calculates a moving distance of the target vehicle in the current road, from a staying time of the target vehicle on the current road and an upper speed limit of the current road included in the acquired meso information. The cooperation unit 13 can obtain a moving distance according to the following formula (11), for example.

[Expression 11]

$$d\_i = Vmax\_i * t\_i \qquad \cdots (11)$$

Here, d_i indicates a moving distance. Furthermore, t_i indicates a staying time. Furthermore, Vmax_i indicates an upper speed limit. The cooperation unit 13 can acquire the upper speed limit from the map information acquired from the map management unit 14.

Next, the cooperation unit 13 instructs the meso simulator 16 to delete the information regarding the target vehicle from the queue of the current road in the meso road information in the meso information and to delete the information regarding the target vehicle from the meso vehicle information. In this case, all the vehicles existing on the current road are finally deleted from the queue. Therefore, if there is no vehicle in the queue, the cooperation unit 13 instructs the meso simulator 16 to delete the current road from the meso road information. Furthermore, the cooperation unit 13 generates micro information in which the target vehicle exists at a position where the target vehicle travels by the calculated moving distance from the starting point of the current road. Then, the cooperation unit 13 outputs the generated micro information to the micro simulator 15. As a result, information regarding the target vehicle existing on the road that has changed to the micro model region is added to the micro information.

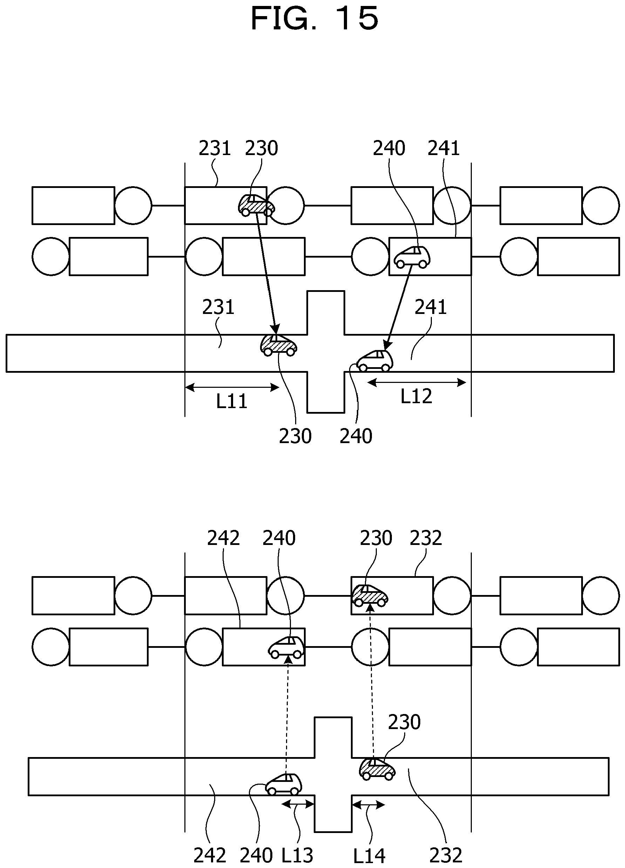

FIG. 15 is a diagram for explaining a method for setting vehicle information in a case where a road on which a vehicle exists is transitioned to a different type of the model region. For example, in a case where a road 231 where a vehicle 230 is traveling has changed from the meso model region to the micro model region, the cooperation unit 13 calculates a distance L11 from a starting point of the road 231 from a staying time stored in a queue of the road 231 and arranges the vehicle 230 at the position. Similarly, in a case where a road 241 where a vehicle 240 is traveling has changed from the meso model region to the micro model region, the cooperation unit 13 calculates a distance L12 from a starting point of the road 241 from a staying time stored in a queue of the road 241 and arranges the vehicle 240 at the position.

Conversely, in a case where the previous model region is the micro model region and the current model region is the meso model region, the cooperation unit 13 determines that the road on which the target vehicle exists has changed from the micro model region to the meso model region, as in the transition from the state 152 to the state 153 in FIG. 14. Then, the cooperation unit 13 acquires the micro information of the target vehicle from the micro simulator 15. Next, the cooperation unit 13 acquires a speed and a position of the target vehicle from the acquired micro information. Then, the cooperation unit 13 calculates a staying time on the current road from the speed and the position of the target vehicle. The cooperation unit 13 can obtain the staying time according to the following formula (12), for example.
[Expression 12]

$$t\_i = d\_i/v\_i \qquad \cdots (12)$$

Here, t_i indicates a staying time. Furthermore, v_i indicates a speed of the target vehicle, and d_i indicates a distance from a starting point of the current road to a position of the target vehicle at that time. For example, the cooperation unit 13 can calculate a distance from the starting point of the current road to the position of the target vehicle at that time, from positional information of a polygonal line representing each road included in another piece of information of the road information and information regarding the position of the target vehicle.

Thereafter, the cooperation unit 13 notifies the micro simulator 15 of an instruction to delete the information regarding the target vehicle from the micro information. Moreover, the cooperation unit 13 generates the meso vehicle information in which the staying time of the target vehicle on the current road is registered. Then, the cooperation unit 13 outputs the generated meso vehicle information to the meso simulator 16. Furthermore, the cooperation unit 13 notifies the meso simulator 16 of an instruction to add the information regarding the target vehicle to the queue of the current road in the meso road information in the meso information, according to the staying time of the target vehicle. However, in a case where the information regarding the current road does not exist in the meso road information in the meso information, the cooperation unit 13 generates meso road information of the current road in which the target vehicle is added to the queue of the current road. Then, the cooperation unit 13 outputs the generated meso road information to the meso simulator 16. As a result, information regarding the target vehicle that exists on the road that has changed to the meso model region is added to the meso information.

For example, as illustrated in FIG. 15, in a case where a road 232 where the vehicle 230 is traveling has changed from the micro model region to the meso model region, the cooperation unit 13 calculates a staying time using a distance L14 from a starting point of the road 232 and a speed of the vehicle 230 and stores the vehicle 230 in a queue of the road 232. Similarly, in a case where a road 242 where the vehicle 240 is traveling has changed from the micro model region to the meso model region, the cooperation unit 13 calculates a staying time using a distance L13 from a starting point of the road 242 and a speed of the vehicle 240 and stores the vehicle 240 in a queue of the road 242.

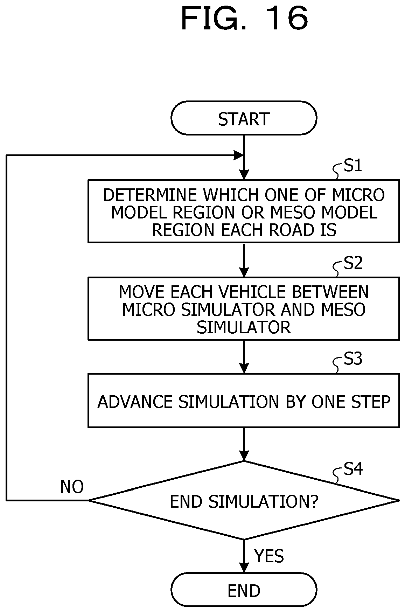

FIG. 16 is a flowchart illustrating an operation of an entire simulation. Next, a flow of an entire simulation by the traffic simulation device 1 will be described with reference to FIG. 16.

The region determination unit 12 of the traffic simulation device 1 determines which one of the micro model region or the meso model region each road is (step S1).

Next, the cooperation unit 13 of the traffic simulation device 1 moves each vehicle between the micro simulator 15 and the meso simulator 16 based on the model region of each road and movement of each vehicle (step S2).

Thereafter, the step control unit 11 of the traffic simulation device 1 advances the simulation by one step (step S3).

Then, the step control unit 11 determines whether the simulation ends according to whether the total number of steps has reached the number of ending steps (step S4). In a case where the simulation has not ended yet (step S4: No), the simulation execution processing returns to step S1.

On the other hand, in a case where the simulation ends (step S4: Yes), the traffic simulation device 1 ends the simulation.

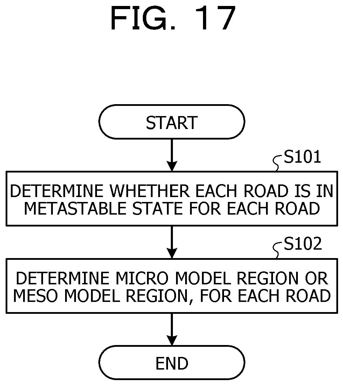

FIG. 17 is a flowchart of processing for dividing a road into the micro model region and the meso model region. The processing illustrated in the flow in FIG. 17 corresponds to an example of the processing executed in step S1 in FIG. 16. Next, a flow of the processing for dividing the road into the micro model region and the meso model region by the region determination unit 12 will be described with reference to FIG. 17.

The region determination unit 12 specifies a curve that represents a relationship between the vehicle density and the traffic flow from the vehicle speed of each road, using the relationship between the vehicle density and the traffic flow according to the vehicle speed as illustrated in FIG. 7. Then, the region determination unit 12 obtains a vehicle density from a vehicle distribution at that time and determines whether the target road is in the metastable state from the vehicle density at that time, using the specified curve (step S101).

Next, the region determination unit 12 determines which one of the micro model region or the meso model region the road is, using the determination result indicating whether the target road is in the metastable state and the input traffic flow and the output traffic flow, for each road (step S102).

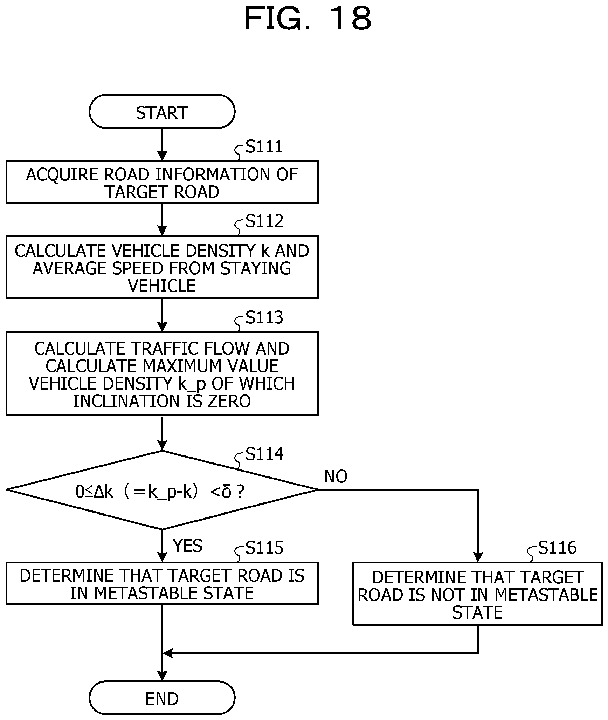

FIG. 18 is a flowchart of processing for determining whether the metastable state is established. The processing illustrated in the flow in FIG. 18 corresponds to an example of the processing executed in step S101 in FIG. 17. Next, a flow of the processing for determining whether the target road is in the metastable state by the region determination unit 12 will be described with reference to FIG. 18. In the following description, a flow of processing for one target road will be described. The region determination unit 12 executes similar processing on all the roads.

The region determination unit 12 acquires road information of the target road from the road information storage unit 24 (step S111). Then, the region determination unit 12 specifies a type of a model region of the target road at that time.

Next, the region determination unit 12 acquires vehicle information of a vehicle on the target road. Furthermore, the region determination unit 12 acquires map information of the target road. Then, the region determination unit 12 extracts a length and an upper speed limit of the target road from the map information. Next, the region determination unit 12 obtains a vehicle density $k$ and a vehicle average speed $v$ of the target road (step S112). Specifically, in a case where the target road is the micro model region, the region determination unit 12 calculates a vehicle density $k = n/\sum\Delta x\_i$ from the number of vehicles $n$ existing on the target road and an inter-vehicle distance $\Delta x\_i$. Furthermore, the region determination unit 12 calculates an average value of speeds of respective vehicles existing on the target road as the vehicle average speed $v$. On the other hand, in a case where the target road is the meso model region, the region determination unit 12 calculates the vehicle density $k$ as $k = n/L$ from the number of vehicles $n$ and the road length $L$. Furthermore, the region determination unit 12 calculates the vehicle average speed $v$ using the formula (1) according to the optimum speed model.

Next, the region determination unit 12 obtains the traffic flow $Q$ from the formula (2), using the calculated vehicle density $k$ and vehicle average speed $v$. Next, the region determination unit 12 calculates the maximum value vehicle density $k\_p$ with the maximum value of the traffic flow $Q$ (step S113).

Next, the region determination unit 12 obtains a difference $\Delta k = k\_p - k$ between the vehicle density $k$ and the maximum value vehicle density $k\_p$ at that time. Then, the region determination unit 12 determines whether the difference $\Delta k$ is equal to or more than zero and is smaller than the set value $\delta$ (step S114).

In a case where the difference $\Delta k$ is equal to or more than zero and is smaller than the set value $\delta$ (step S114: Yes), the region determination unit 12 determines that the target road is in the metastable state (step S115).

On the other hand, in a case where the difference $\Delta k$ is less than zero and is equal to or more than the set value $\delta$ (step S114: No), the region determination unit 12 determines that the target road is not in the metastable state (step S116).

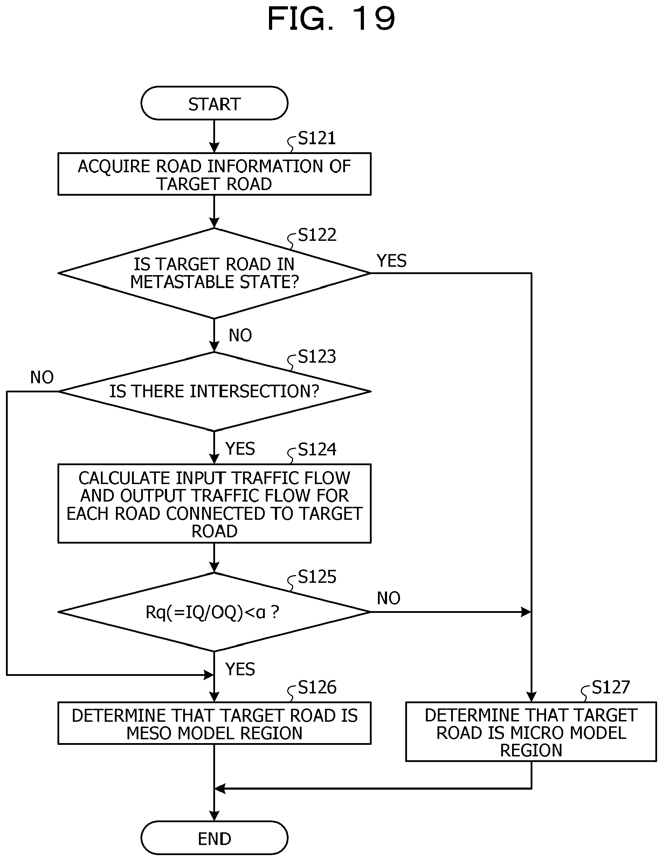

FIG. 19 is a flowchart of processing for determining a model region of the target road. The processing illustrated in the flow in FIG. 19 corresponds to an example of the processing executed in step S102 in FIG. 17. Next, a flow of the processing for determining the model region of the target road by the region determination unit 12 will be described with reference to FIG. 19. In the following description, a flow of processing for one target road will be described. The region determination unit 12 executes similar processing on all the roads.

The region determination unit 12 acquires information obtained by adding a determination result indicating whether the target road is in the metastable state to the road information of the target road (step S121).

Next, the region determination unit 12 determines whether the target road is in the metastable state (step S122). In a case where the target road is not in the metastable state (step S122: No), the region determination unit 12 determines whether there is an intersection at an end of the target road, using the road information (step S123). In a case where there is no intersection at the end of the target road (step S123: No), the region determination unit 12 proceeds the processing to step S126.

On the other hand, in a case where there is an intersection at the end of the target road (step S123: Yes), the region determination unit 12 calculates an input traffic flow and an output traffic flow of each road connected to the target road (step S124). Specifically, regarding a connection destination road of the target road, the region determination unit 12 assumes a road connected at an ending point, including the target road, as a road $u_i$ ($i = 1,..., n_u$) and assumes a road connected at a starting point as a road $d_j$ ($j = 1,..., n_d$). Next, if the road $u_i$ is the micro model region at this time, the region determination unit 12 calculates an average value of speeds of all vehicles existing on the road $u_i$ as the vehicle speed $v_i$ and calculates a total sum of the inter-vehicle distances of the respective vehicles as the vehicle line length $L_i$. Conversely, if the road $u_i$ is the meso model region, the region determination unit 12 assumes the vehicle speed $v_i$ as an upper speed limit and the vehicle line length $L_i$ as a road length. Moreover, the region determination unit 12 calculates an input traffic flow $iq_i$ from each road $u_i$ to the intersection at the end of the target road, using the formula (7). Then, the region determination unit 12 calculates a total sum of the input traffic flows $iq_i$ to the respective roads $u_i$ ($i = 1,..., n_u$) as the input traffic flow IQ to the target road, using the formula (8). Furthermore, for the road $d_j$ ($j = 1,..., n_d$), the region determination unit 12 obtains the number of vehicles $n_j$ (vehicle), a vehicle speed $v_j$ (m/s), and a vehicle line length $L_j$ (m) with a method similar to that of the road $u_i$. Thereafter, the region determination unit 12 calculates the output traffic flow $oq_j$ from the intersection at the end of the target road to each road $d_j$, using the formula (9). Next, the region determination unit 12 calculates a total sum of the output traffic flows $oq_j$ of the respective roads $d_j$ ($j = 1,..., n_d$) as the output traffic flow OQ from the target road, using the formula (10).

Next, the region determination unit 12 calculates a ratio Rq = IQ/OQ between the input traffic flow IQ and the output traffic flow OQ. Then, the region determination unit 12 determines whether the ratio Rq is less than preset $\alpha$ (step S125).

In a case where there is no intersection at the end of the target road (step S123: No) or in a case where the ratio Rq is less than $\alpha$ (step S125: Yes), the region determination unit 12 determines that the target road is the meso model region (step S126).

On the other hand, in a case where the target road is in the metastable state (step S122: Yes) or in a case where the ratio Rq is equal to or more than $\alpha$ (step S125: No), the region determination unit 12 determines that the target road is the micro model region (step S127).

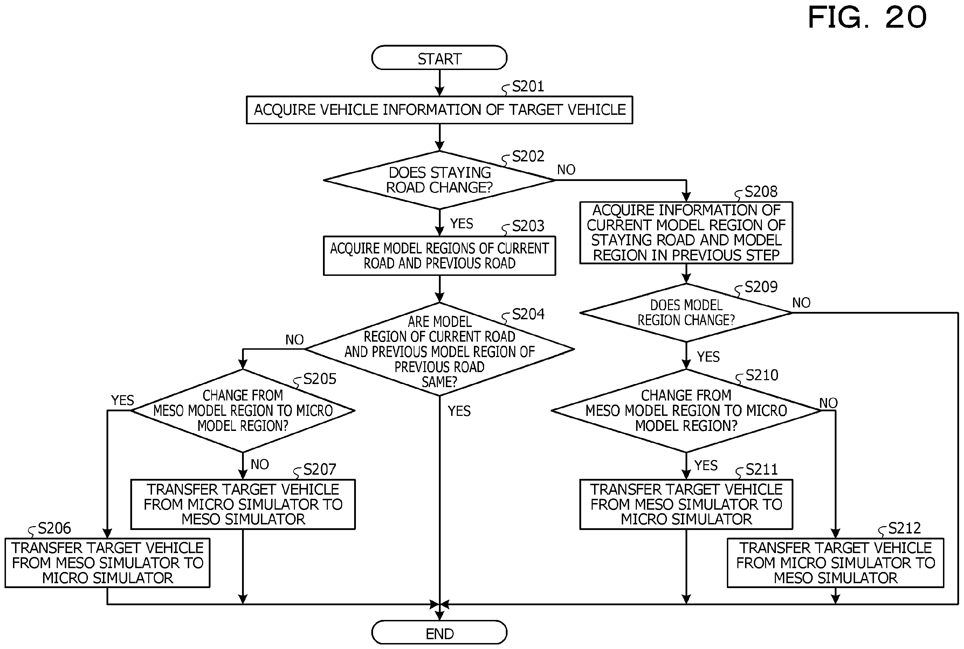

FIG. 20 is a flowchart of vehicle transfer processing between simulators. The processing illustrated in the flow in FIG. 20 corresponds to an example of the processing executed in step S2 in FIG. 16. Next, a flow of the vehicle transfer processing between the simulators by the cooperation unit 13 will be described with reference to FIG. 20. In the following description, a flow of processing for one target vehicle will be described. The cooperation unit 13 executes similar processing on all the vehicles.

The cooperation unit 13 acquires vehicle information of the target vehicle from the vehicle information storage unit 23 (step S201). Furthermore, the cooperation unit 13 acquires road information from the road information storage unit 24. Moreover, the cooperation unit 13 acquires the road information from the map management unit 14.

Next, the cooperation unit 13 compares a current road on which the target vehicle exists in a step at that time and a previous road on which the target vehicle has existed in the previous step and determines whether a staying road where the target vehicle stays changes (step S202).

In a case where the current road and the previous road are different (step S202: Yes), the cooperation unit 13 acquires a model region of the current road and a model region of the previous road from the road information (step S203).

Next, the cooperation unit 13 determines whether the model region of the current road and the previous model region of the previous road are the same (step S204). In a case where the model region of the current road and the previous model region of the previous road match (step S204: Yes), the cooperation unit 13 ends the vehicle transfer processing between the simulators for the target vehicle.

On the other hand, in a case where the model region of the current road and the previous model region of the previous road are different (step S204: No), the cooperation unit 13 determines whether the model region of the staying road has changed from the meso model region to the micro model region due to movement of the vehicle (step S205).

In a case where the model region of the staying road has changed from the meso model region to the micro model region due to the movement of the vehicle (step S205: Yes), the target vehicle is transferred from the meso simulator 16 to the micro simulator 15 (step S206).

On the other hand, in a case where the model region of the staying road has changed from the micro model region to the meso model region due to the movement of the vehicle (step S205: No), the target vehicle is transferred from the micro simulator 15 to the meso simulator 16 (step S207).

On the other hand, in a case where the current road and the previous road are the same (step S202: No), the cooperation unit 13 acquires information regarding the current model region of the staying road and the model region in the previous step (step S208).

Next, the cooperation unit 13 determines whether the model region of the staying road of the target vehicle changes (step S209). In a case where the model region of the staying road of the target vehicle does not change (step S209: Not), the cooperation unit 13 ends the vehicle movement processing between the simulators for the target vehicle.

On the other hand, in a case where the model region of the staying road of the target vehicle changes (step S209: Yes), the cooperation unit 13 determines where the model region of the staying road of the target vehicle has changed from the meso model region to the micro model region (step S210).

In a case where the model region of the staying road of the target vehicle has changed from the meso model region to the micro model region (step S210: Yes), the target vehicle is transferred from the meso simulator 16 to the micro simulator 15 (step S211).

On the other hand, in a case where the model region of the staying road of the target vehicle has changed from the micro model region to the meso model region (step S210: No), the target vehicle is transferred from the micro simulator 15 to the meso simulator 16 (step S212).

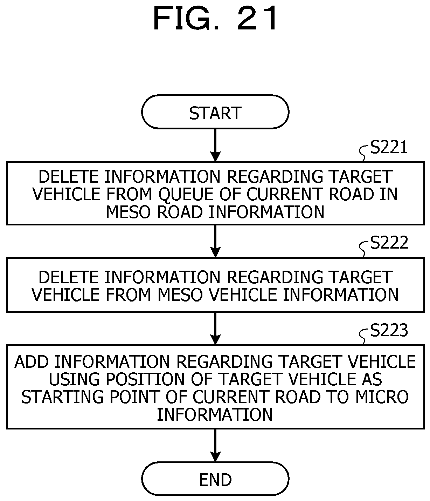

FIG. 21 is a flowchart of transfer processing of a vehicle that moves from the meso model region to the micro model region. The processing illustrated in the flow in FIG. 21 corresponds to an example of the processing executed in step S206 in FIG. 20. Next, a flow of the transfer processing of the vehicle that moves from the meso model region to the micro model region by the cooperation unit 13 will be described with reference to FIG. 21.

The cooperation unit 13 instructs the meso simulator 16 to delete the information regarding the target vehicle from the meso road information and deletes the information regarding the target vehicle from the queue of the current road of the target vehicle in the meso road information (step S221).

Next, the cooperation unit 13 instructs the meso simulator 16 to delete the information regarding the target vehicle from the meso vehicle information (step S222).

Moreover, the cooperation unit 13 generates micro information indicating that the target vehicle exists at a position of a starting point of the current road. Then, the cooperation unit 13 outputs the generated micro information to the micro simulator 15 and adds information regarding the target vehicle using the position of the target vehicle as the starting point of the current road to the micro information (step S223).

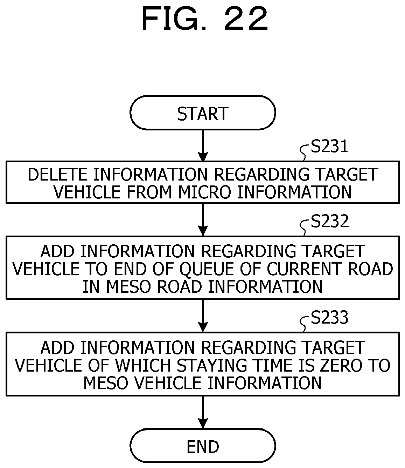

FIG. 22 is a flowchart of movement processing of a vehicle that moves from the micro model region to the meso model region. The processing illustrated in the flow in FIG. 22 corresponds to an example of the processing executed in step S207 in FIG. 20. Next, a flow of transfer processing of the vehicle that moves from the micro model region to the meso model region by the cooperation unit 13 will be described with reference to FIG. 22.

The cooperation unit 13 instructs the micro simulator 15 to delete the information regarding the target vehicle from the micro information (step S231).

Next, the cooperation unit 13 instructs the meso simulator 16 to perform addition to the meso road information of the target vehicle and adds the information regarding the target vehicle to the end of the queue of the current road of the target vehicle in the meso road information (step S232).

Moreover, the cooperation unit 13 generates meso vehicle information in the meso information indicating that the target vehicle exists on the current road and the staying time is zero. Then, the cooperation unit 13 outputs the generated meso vehicle information to the meso simulator 16 and adds the information regarding the target vehicle of which the staying time is zero to the meso vehicle information (step S233).

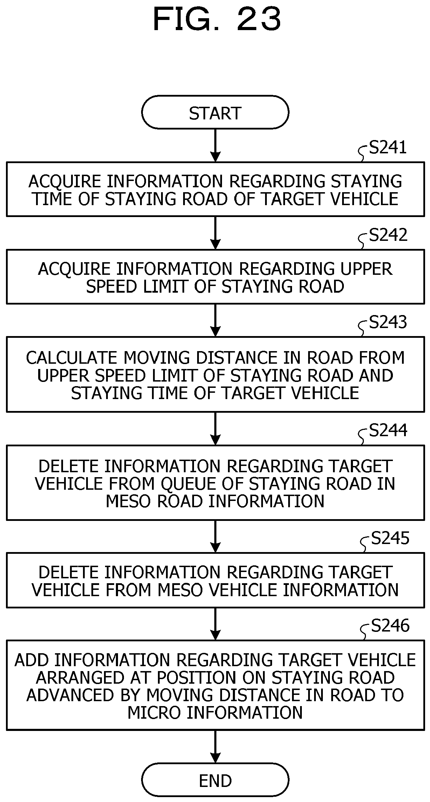

FIG. 23 is a flowchart of transfer processing of a vehicle on a road that has changed from the meso model region to the micro model region. The processing illustrated in the flow in FIG. 23 corresponds to an example of the processing executed in step S211 in FIG. 20. Next, a flow of the transfer processing of the vehicle on the road that has changed from the meso model region to the micro model region by the cooperation unit 13 will be described with reference to FIG. 23.

The cooperation unit 13 acquires the information regarding the target vehicle in the meso information from the meso simulator 16. Then, the cooperation unit 13 acquires information regarding a staying time on a staying road of the target vehicle from the acquired meso information regarding the target vehicle (step S241).

Next, the cooperation unit 13 acquires map information from the map management unit 14 and acquires information regarding an upper speed limit of the staying road from the map information (step S242).

Next, the cooperation unit 13 calculates a moving distance in the road that is a moving distance in the staying road of the target vehicle from the upper speed limit of the staying road and the staying time of the target vehicle, using the formula (11) (step S243).

Next, the cooperation unit 13 instructs the meso simulator 16 to delete the information regarding the target vehicle from the meso road information in the meso information and deletes the information regarding the target vehicle from a queue of the staying road in the meso road information (step S244).

Moreover, the cooperation unit 13 instructs the meso simulator 16 to delete the information regarding the target vehicle from the meso vehicle information (step S245).

Next, the cooperation unit 13 generates micro information by arranging the target vehicle at a position advanced from the starting point of the current road by the moving distance in the road. Then, the cooperation unit 13 outputs the generated micro information to the micro simulator 15 and adds the information regarding the target vehicle arranged at the position on the staying road advanced by the moving distance in the road to the micro information (step S246).

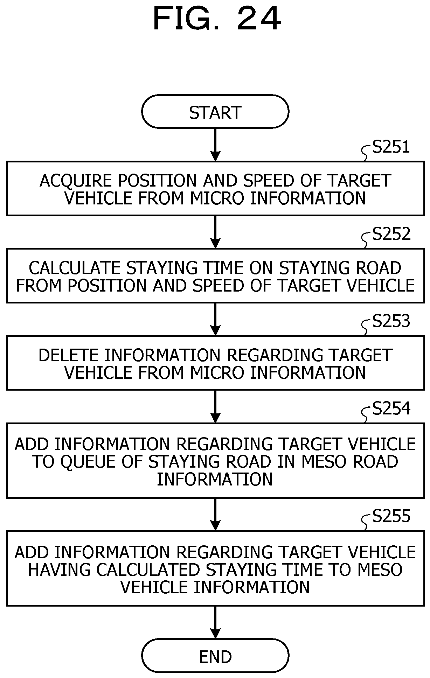

FIG. 24 is a flowchart of transfer processing of a vehicle on a road that has changed from the micro model region to the meso model region. The processing illustrated in the flow in FIG. 24 corresponds to an example of the processing executed in step S212 in FIG. 20. Next, a flow of the transfer processing of the vehicle on the road that has changed from the micro model region to the meso model region by the cooperation unit 13 will be described with reference to FIG. 24.

The cooperation unit 13 acquires information regarding the target vehicle in the micro information from the micro simulator 15. Then, the cooperation unit 13 acquires a position and a speed of the target vehicle from the acquired micro information of the target vehicle (step S251).

Next, the cooperation unit 13 calculates a staying time on a staying road from the speed and the position of the target vehicle, using the formula (12) (step S252).

Next, the cooperation unit 13 instructs the micro simulator 15 to delete the information regarding the target vehicle from the micro information (step S253).

Next, the cooperation unit 13 instructs the meso simulator 16 to add the information regarding the target vehicle to the meso road information in the meso information and adds the information regarding the target vehicle to a queue of the staying road in the meso road information according to the staying time of the target vehicle (step S254).

Furthermore, the cooperation unit 13 generates meso vehicle information in which the staying time of the target vehicle on the staying road is registered. Then, the cooperation unit 13 outputs the generated meso vehicle information to the meso simulator 16 and adds the information regarding the target vehicle having the calculated staying time to the meso vehicle information (step S255).

As described above, the traffic simulation device according to the present embodiment determines whether the road is in the metastable state. Then, the traffic simulation device determines which one of the micro model region or the meso model region each road is, using the determination result regarding the metastable state and the input traffic flow and the output traffic flow to the road.

As a result, the traffic simulation device according to the present embodiment can detect a region where a congestion is likely to occur, not a region where a congestion occurs. Then, the traffic simulation device according to the present embodiment performs a simulation using the micro model on the region where a congestion is likely to occur and performs a simulation using the meso model in the other region. Then, the simulation using the micro model and the simulation using the meso model are shared and executed by different simulators. As a result, it is possible to realize a simulation with high accuracy while suppressing a simulation region with high resolution. Therefore, it is possible to obtain a result equivalent to the simulation in a wide area and with high resolution, with low calculation cost while suppressing a calculation amount.

(Hardware Configuration)

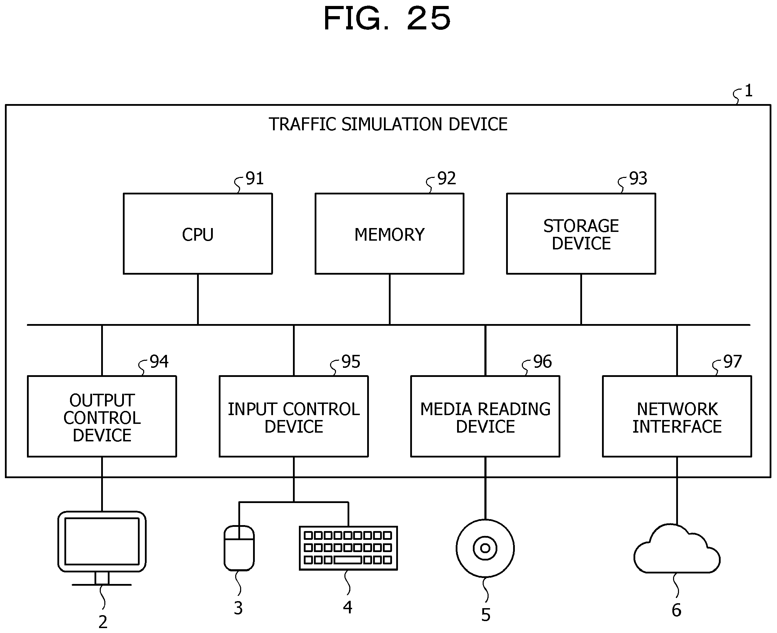

FIG. 25 is a hardware configuration diagram of the traffic simulation device according to the embodiment. Next, an example of a hardware configuration that implements the traffic simulation device 1 according to the embodiment will be described with reference to FIG. 25.

As illustrated in FIG. 25, the traffic simulation device 1 includes, for example, a central processing unit (CPU) 91, a memory 92, a storage device 93, an output control device 94, an input control device 95, a media reading device 96, and a network interface 97.

The CPU 91 is connected to each of the memory 92, the storage device 93, the output control device 94, the input control device 95, the media reading device 96, and the network interface 97 via a bus.

The output control device 94 is connected to a monitor 2 or the like. Then, the output control device 94 displays data such as an image specified by the CPU 91 on the monitor 2.

The input control device 95 is connected to a mouse 3, a keyboard 4, or the like. Then, the input control device 95 transfers information input using the mouse 3, the keyboard 4, or the like to the CPU 91.

The media reading device 96 is a digital versatile disc (DVD) drive or the like. The media reading device 96 reads data from a portable storage medium 5 such as a DVD and writes data to the portable storage medium 5.

The network interface 97 is a communication interface between the traffic simulation device 1 and an external device. The network interface 97 is connected to a network 6 and relays communication between the CPU 91 and the external device via the network 6.

The storage device 93 is an auxiliary storage device such as a hard disk drive or a solid state drive (SSD). The storage device 93 implements functions of the micro information storage unit 21, the meso information storage unit 22, the vehicle information storage unit 23, the road information storage unit 24, and the map information storage unit 25 illustrated in FIG. 1. Furthermore, the storage device 93 stores various programs including programs for implementing functions of the step control unit 11, the region determination unit 12, the cooperation unit 13, the map management unit 14, the micro simulator 15, the meso simulator 16, or the like illustrated in FIG. 1.

The memory 92 is a main storage device. The memory 92 is, for example, a dynamic random access memory (DRAM) or the like.

The CPU 91 reads various programs stored in the storage device 93, develops the programs on the memory 92, and executes the programs. As a result, the CPU 91 implements the functions of the step control unit 11, the region determination unit 12, the cooperation unit 13, the map management unit 14, the micro simulator 15, the meso simulator 16, or the like illustrated in FIG. 1.

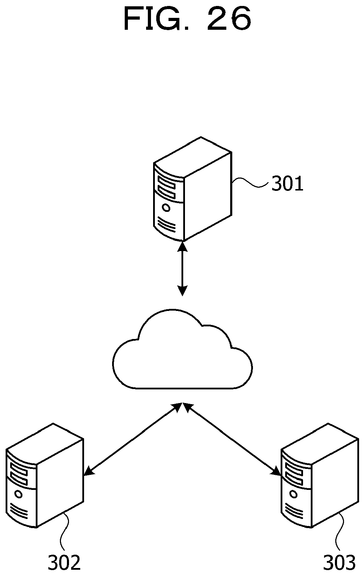

FIG. 26 is a diagram illustrating another configuration example of the traffic simulation device. In FIG. 1, a configuration is illustrated in which the functions of the step control unit 11, the region determination unit 12, the cooperation unit 13, the map management unit 14, the micro simulator 15, the meso simulator 16, or the like are mounted in the traffic simulation device 1 that is a single device. However, a configuration may be used in which some of these functions are included in a different device.

For example, information processing devices 301 to 303 illustrated in FIG. 26 may implement the traffic simulation device 1. The information processing devices 301 to 303 are servers or the like.

For example, the information processing devices 301 to 303 are connected to each other via a network. Then, the information processing device 301 includes the step control unit 11, the region determination unit 12, the cooperation unit 13, the map management unit 14, the vehicle information storage unit 23, the road information storage unit 24, and the map information storage unit 25. Furthermore, the information processing device 302 includes the micro simulator 15 and the micro information storage unit 21. Furthermore, the information processing device 303 includes the meso simulator 16 and the meso information storage unit 22.

In this case, the simulation using the micro model and the simulation using the meso model are respectively executed by different devices, which are, the information processing devices 302 and 303. Then, the information processing device 301 determines a model region of a road and executes vehicle transfer processing between simulators.

## Claims

1.  A simulation method implemented by a computer, the simulation method comprising:

    classifying a plurality of regions into a first region where a first simulation is performed with a predetermined resolution and a second region where a second simulation is performed with a lower resolution than the first region, based on a relationship between a density and a speed of a vehicle in each of the plurality of regions;
    performing the first simulation for the first region; and
    performing the second simulation for the second region.

2.  The simulation method according to claim 1, the simulation method further comprising:
    in a case where it is detected that the relationship between the density and the speed of the vehicle that exists in a specific region classified as the second region satisfies a predetermined condition, changing the specific region to the first region.

3.  The simulation method according to claim 1, the simulation method further comprising:

    obtaining, from a speed of the vehicle in a specific region, a traffic flow function that indicates a relationship between a traffic flow and a vehicle density; and
    in a case where the vehicle density in the specific region is between a first vehicle density at which the traffic flow becomes a maximum value in the traffic flow function and a second vehicle density that is lower by a predetermined amount, classifying the specific region as the first region.

4.  The simulation method according to claim 3, the simulation method further comprising:

    in a case where the vehicle density in the specific region is not between the first vehicle density and the second vehicle density, obtaining an input traffic flow of a vehicle that enters the specific region, and an output traffic flow of a vehicle that moves out from the specific region; and
    in a case where a ratio between the input traffic flow and the output traffic flow is equal to or more than a predetermined value, classifying the specific region as the first region.

5. The simulation method according to claim 1, the simulation method further comprising:

   specifying, from among the plurality of regions, a selection region to be the first region in accordance with the relationship between the density and the speed of the vehicle; and
   classifying, as the first region, the region included in a range where the vehicle is capable to reach in a predetermined time from the selection region.

6. The simulation method according to claim 1, the simulation method further comprising:

   specifying, from among the plurality of regions, a selection region to be the first region in accordance with the relationship between the density and the speed of the vehicle;
   creating, from a combined region that includes the selection region and some of the plurality of regions, a plurality of division patterns by dividing the combined region into different numbers of parts; and
   classifying, as the first region, the region included in the divided region in which a ratio between the number of included selection regions and the number of other regions is equal to or more than a preset value and a value of the ratio becomes minimum, among the divided regions included in the division pattern.

7. A simulation program comprising instructions which, when executed by a computer, cause the computer to execute processing comprising:

   classifying a plurality of regions into a first region where a first simulation is performed with a predetermined resolution and a second region where a second simulation is performed with a lower resolution than the first region, based on a relationship between a density and a speed of a vehicle in each of the plurality of regions;
   performing the first simulation for the first region; and
   performing the second simulation for the second region.

# FIG. 1

# FIG. 2

| ROAD | ROAD LENGTH | UPPER SPEED LIMIT | CONNECTION DESTINATION | OTHERS |
|---|---|---|---|---|
| road11 | 50m | 60km/h | road13, road14, road15 | ... |
| road12 | 100m | 60km/h | road16 | ... |
| ... | ... | ... | ... | ... |

# FIG. 3

| VEHICLE | POSITION | SPEED | ROAD | OTHERS |
|---------|----------|-------|------|--------|
| car01 | (35.383, 139.640) | 50km/h | road01 | ... |
| car02 | (35.382, 139.642) | 52km/h | road02 | ... |
| ... | ... | ... | ... | ... |

# FIG. 4

26

| ROAD | FIFO | OTHERS |
|------|------|--------|
| road21 | car21, car22, ⋯ | ⋯ |
| road22 | car23, car24, ⋯ | ⋯ |
| ⋯ | ⋯ | ⋯ |

27

| VEHICLE | ROAD | STAYING TIME | OTHERS |
|---------|------|--------------|--------|
| car25 | road23 | 10sec | ⋯ |
| car26 | road24 | 15sec | ⋯ |
| ⋯ | ⋯ | ⋯ | ⋯ |

# FIG. 5

# FIG. 6

# FIG. 7

# FIG. 8

| ROAD | MODEL | PREVIOUS MODEL |
|---|---|---|
| road31 | MICRO | MESO |
| road32 | MESO | MESO |
| … | … | … |

FIG. 9

# FIG. 10

# FIG. 11

| VEHICLE | ROAD | PREVIOUS ROAD |
|---------|---------|---------------|
| car31 | road#41 | road#42 |
| car32 | road#43 | road#43 |
| … | … | … |

# FIG. 12

MESO MODEL REGION

MICRO MODEL REGION

141

140

145

MESO MODEL REGION

MICRO MODEL REGION

142

140

145

MESO MODEL REGION

MICRO MODEL REGION

143

140

145

EP 4 261 728 A1

# FIG. 13

# FIG. 14

MESO MODEL
REGION                151

150

MESO MODEL
REGION                152

150

MICRO MODEL
REGION

155

MESO MODEL
REGION                153

150

EP 4 261 728 A1

# FIG. 15

# FIG. 16

```
                    ┌─────────────────┐
                    │      START      │
                    └─────────────────┘
                             │
                             ▼                    ⌐S1
          ┌──────────────────────────────────────┐
          │  DETERMINE WHICH ONE OF MICRO         │
          │  MODEL REGION OR MESO MODEL           │
          │  REGION EACH ROAD IS                  │
          └──────────────────────────────────────┘
                             │
                             ▼                    ⌐S2
          ┌──────────────────────────────────────┐
          │  MOVE EACH VEHICLE BETWEEN            │
          │  MICRO SIMULATOR AND MESO             │
          │  SIMULATOR                            │
          └──────────────────────────────────────┘
                             │
                             ▼                    ⌐S3
          ┌──────────────────────────────────────┐
          │  ADVANCE SIMULATION BY ONE STEP       │
          └──────────────────────────────────────┘
                             │
                             ▼                    ⌐S4
   NO                  ◇─────────────────◇
 ◄───────────         END SIMULATION?
                            ◇─────────◇
                             │ YES
                             ▼
                    ┌─────────────────┐
                    │       END       │
                    └─────────────────┘
```

# FIG. 17

```
        ┌─────────────────┐
        │      START       │
        └────────┬────────┘
                 │
                 ▼          ⌐S101
   ┌─────────────────────────────────┐
   │ DETERMINE WHETHER EACH ROAD IS IN│
   │  METASTABLE STATE FOR EACH ROAD  │
   └────────────────┬────────────────┘
                    │
                    ▼          ⌐S102
   ┌─────────────────────────────────┐
   │ DETERMINE MICRO MODEL REGION OR  │
   │ MESO MODEL REGION, FOR EACH ROAD │
   └────────────────┬────────────────┘
                    │
                    ▼
        ┌─────────────────┐
        │       END        │
        └─────────────────┘
```

# FIG. 18

```
                    ┌──────────────┐
                    │    START     │
                    └──────────────┘
                           │
                           ▼           ⌐S111
          ┌────────────────────────────────┐
          │  ACQUIRE ROAD INFORMATION OF   │
          │          TARGET ROAD           │
          └────────────────────────────────┘
                           │
                           ▼           ⌐S112
          ┌────────────────────────────────┐
          │ CALCULATE VEHICLE DENSITY k AND│
          │  AVERAGE SPEED FROM STAYING    │
          │            VEHICLE             │
          └────────────────────────────────┘
                           │
                           ▼           ⌐S113
          ┌────────────────────────────────┐
          │  CALCULATE TRAFFIC FLOW AND    │
          │   CALCULATE MAXIMUM VALUE      │
          │ VEHICLE DENSITY k_p OF WHICH   │
          │     INCLINATION IS ZERO        │
          └────────────────────────────────┘
                           │
                           ▼           ⌐S114
                    ◇──────────────◇          NO
          ◇  0≤Δk（=k_p-k）<δ ?  ◇──────────────┐
                    ◇──────────────◇              │
                           │ YES     ⌐S115        │ ⌐S116
          ┌────────────────────────┐   ┌──────────────────────┐
          │ DETERMINE THAT TARGET  │   │ DETERMINE THAT TARGET│
          │ ROAD IS IN METASTABLE  │   │ ROAD IS NOT IN       │
          │        STATE           │   │ METASTABLE STATE     │
          └────────────────────────┘   └──────────────────────┘
                           │                      │
                           ◄──────────────────────┘
                           ▼
                    ┌──────────────┐
                    │     END      │
                    └──────────────┘
```

# FIG. 19

START

↓

ACQUIRE ROAD INFORMATION OF TARGET ROAD $\quad$ S121

↓

IS TARGET ROAD IN METASTABLE STATE? $\quad$ S122 — YES →

↓ NO

IS THERE INTERSECTION? $\quad$ S123

← NO

↓ YES $\quad$ S124

CALCULATE INPUT TRAFFIC FLOW AND OUTPUT TRAFFIC FLOW FOR EACH ROAD CONNECTED TO TARGET ROAD

↓

$Rq(=IQ/OQ)<a$ ? $\quad$ S125 — NO →

↓ YES

DETERMINE THAT TARGET ROAD IS MESO MODEL REGION $\quad$ S126

DETERMINE THAT TARGET ROAD IS MICRO MODEL REGION $\quad$ S127

↓

END

FIG. 20

START

S201
ACQUIRE VEHICLE INFORMATION OF TARGET VEHICLE

S202
DOES STAYING ROAD CHANGE? — NO

YES S203
ACQUIRE MODEL REGIONS OF CURRENT ROAD AND PREVIOUS ROAD

S208
ACQUIRE INFORMATION OF CURRENT MODEL REGION OF STAYING ROAD AND MODEL REGION IN PREVIOUS STEP

S204
ARE MODEL REGION OF CURRENT ROAD AND PREVIOUS MODEL REGION OF PREVIOUS ROAD SAME?

NO

S209
DOES MODEL REGION CHANGE? — NO

YES

S205
CHANGE FROM MESO MODEL REGION TO MICRO MODEL REGION?

YES

NO

S210
CHANGE FROM MESO MODEL REGION TO MICRO MODEL REGION?

NO

S207
TRANSFER TARGET VEHICLE FROM MICRO SIMULATOR TO MESO SIMULATOR

YES

S211
TRANSFER TARGET VEHICLE FROM MESO SIMULATOR TO MICRO SIMULATOR

S206
TRANSFER TARGET VEHICLE FROM MESO SIMULATOR TO MICRO SIMULATOR

S212
TRANSFER TARGET VEHICLE FROM MICRO SIMULATOR TO MESO SIMULATOR

END

# FIG. 21

```
                    ┌─────────────┐
                    │    START    │
                    └─────────────┘
                           │
                           │         ⌐S221
                           ▼
    ┌──────────────────────────────────────────┐
    │  DELETE INFORMATION REGARDING TARGET      │
    │  VEHICLE FROM QUEUE OF CURRENT ROAD IN     │
    │  MESO ROAD INFORMATION                     │
    └──────────────────────────────────────────┘
                           │
                           │         ⌐S222
                           ▼
    ┌──────────────────────────────────────────┐
    │  DELETE INFORMATION REGARDING TARGET      │
    │  VEHICLE FROM MESO VEHICLE INFORMATION     │
    └──────────────────────────────────────────┘
                           │
                           │         ⌐S223
                           ▼
    ┌──────────────────────────────────────────┐
    │  ADD INFORMATION REGARDING TARGET VEHICLE  │
    │  USING POSITION OF TARGET VEHICLE AS       │
    │  STARTING POINT OF CURRENT ROAD TO MICRO   │
    │  INFORMATION                               │
    └──────────────────────────────────────────┘
                           │
                           ▼
                    ┌─────────────┐
                    │     END     │
                    └─────────────┘
```

# FIG. 22

START

S231

DELETE INFORMATION REGARDING TARGET
VEHICLE FROM MICRO INFORMATION

S232

ADD INFORMATION REGARDING TARGET
VEHICLE TO END OF QUEUE OF CURRENT ROAD
IN MESO ROAD INFORMATION

S233

ADD INFORMATION REGARDING TARGET
VEHICLE OF WHICH STAYING TIME IS ZERO TO
MESO VEHICLE INFORMATION

END

# FIG. 23

START

⌐S241

ACQUIRE INFORMATION REGARDING STAYING
TIME OF STAYING ROAD OF TARGET VEHICLE

⌐S242

ACQUIRE INFORMATION REGARDING UPPER
SPEED LIMIT OF STAYING ROAD

⌐S243

CALCULATE MOVING DISTANCE IN ROAD FROM
UPPER SPEED LIMIT OF STAYING ROAD AND
STAYING TIME OF TARGET VEHICLE

⌐S244

DELETE INFORMATION REGARDING TARGET
VEHICLE FROM QUEUE OF STAYING ROAD IN
MESO ROAD INFORMATION

⌐S245

DELETE INFORMATION REGARDING TARGET
VEHICLE FROM MESO VEHICLE INFORMATION

⌐S246

ADD INFORMATION REGARDING TARGET VEHICLE
ARRANGED AT POSITION ON STAYING ROAD
ADVANCED BY MOVING DISTANCE IN ROAD TO
MICRO INFORMATION

END

# FIG. 24

START

S251

ACQUIRE POSITION AND SPEED OF TARGET
VEHICLE FROM MICRO INFORMATION

S252

CALCULATE STAYING TIME ON STAYING ROAD
FROM POSITION AND SPEED OF TARGET VEHICLE

S253

DELETE INFORMATION REGARDING TARGET
VEHICLE FROM MICRO INFORMATION

S254

ADD INFORMATION REGARDING TARGET VEHICLE
TO QUEUE OF STAYING ROAD IN MESO ROAD
INFORMATION

S255

ADD INFORMATION REGARDING TARGET VEHICLE
HAVING CALCULATED STAYING TIME TO MESO
VEHICLE INFORMATION

END

# FIG. 25

TRAFFIC SIMULATION DEVICE — 1

- CPU — 91
- MEMORY — 92
- STORAGE DEVICE — 93
- OUTPUT CONTROL DEVICE — 94
- INPUT CONTROL DEVICE — 95
- MEDIA READING DEVICE — 96
- NETWORK INTERFACE — 97

2, 3, 4, 5, 6

# FIG. 26

Europäisches
Patentamt

European
Patent Office

Office européen
des brevets

# EUROPEAN SEARCH REPORT

Application Number

EP 23 15 1984

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | LIYAN ZHANG ET AL: "A Novel Meso-Dynamic Simulation Model of Traffic Flow", REMOTE SENSING, ENVIRONMENT AND TRANSPORTATION ENGINEERING (RSETE), 2012 2ND INTERNATIONAL CONFERENCE ON, IEEE, 1 June 2012 (2012-06-01), pages 1-4, XP032218326, DOI: 10.1109/RSETE.2012.6260365 ISBN: 978-1-4673-0872-4 * abstract * * page 1, column 2 - page 4 * ----- | 1-7 | INV. G06F30/13 G06F30/20 G06F30/15 |
| X | JIAN MA ET AL: "A study on multi-resolution scheme of macroscopic-microscopic traffic simulation model", INTELLIGENT TRANSPORTATION SYSTEMS (ITSC), 2011 14TH INTERNATIONAL IEEE CONFERENCE ON, IEEE, 5 October 2011 (2011-10-05), pages 1421-1426, XP032023453, DOI: 10.1109/ITSC.2011.6083058 ISBN: 978-1-4577-2198-4 * abstract * * page 1421 - page 1425 * ----- | 1-7 | |
| X | LECLERCQ ET AL: "Hybrid approaches to the solutions of the ''Lighthill-Whitham-Richards'' model", TRANSPORTATION RESEARCH PART B. METHODOLOGICAL, OXFORD, GB, vol. 41, no. 7, 27 April 2007 (2007-04-27) , pages 701-709, XP022049078, ISSN: 0191-2615, DOI: 10.1016/J.TRB.2006.11.004 * abstract * * page 1 - page 6 * * page 2; figure 2 * ----- -/-- | 1-7 | |

**TECHNICAL FIELDS SEARCHED (IPC)**

G06F

The present search report has been drawn up for all claims

| Place of search | Date of completion of the search | Examiner |
|---|---|---|
| Munich | 29 August 2023 | Radev, Boyan |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

& : member of the same patent family, corresponding
document

EPO FORM 1503 03.82 (P04C01)

Europäisches
Patentamt

European
Patent Office

Office européen
des brevets

# EUROPEAN SEARCH REPORT

Application Number

EP 23 15 1984

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | ZEHE DANIEL DANIEL ZEHE@TUM-CREATE EDU SG ET AL: "Traffic Simulation Performance Optimization through Multi-Resolution Modeling of Road Segments", PROCEEDINGS OF THE 14TH INTERNATIONAL CONFERENCE ON INTERACTION DESIGN AND CHILDREN, ACMPUB27, NEW YORK, NY, USA, 10 June 2015 (2015-06-10), pages 281-288, XP058513304, DOI: 10.1145/2769458.2769475 ISBN: 978-1-4503-3638-3 * abstract * * page 281, column 2 - page 287 * ----- | 1-7 | |
| X | NAJIA BOUHA ET AL: "A First Step Towards Dynamic Hybrid Traffic Modeling", ARXIV.ORG, CORNELL UNIVERSITY LIBRARY, 201 OLIN LIBRARY CORNELL UNIVERSITY ITHACA, NY 14853, 27 May 2015 (2015-05-27), XP080803173, * abstract * * page 1 - page 6 * ----- | 1-7 | |

TECHNICAL FIELDS SEARCHED (IPC)

The present search report has been drawn up for all claims

| Place of search | Date of completion of the search | Examiner |
|---|---|---|
| Munich | 29 August 2023 | Radev, Boyan |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2002269670 A